# EUROPEAN PATENT SPECIFICATION

(11) **EP 4 451 171 B1**
(45) Date of publication and mention of the grant of the patent: **11.03.2026**
(21) Application number: 23817933.7
(22) Date of filing: 03.11.2023
(51) Int. Cl.: G06K 13/08, H04B 1/3818, H04M 1/02, H01R 12/70, H01R 13/703

(54) **SOCKET FOR MOUNTING STORAGE MEDIUM TRAY AND ELECTRONIC DEVICE COMPRISING SAME**
BUCHSE ZUR MONTAGE EINER SPEICHERMEDIUMABLAGE UND ELEKTRONISCHE VORRICHTUNG DAMIT
SUPPORT POUR MONTER UN PLATEAU DE SUPPORT DE STOCKAGE ET DISPOSITIF ÉLECTRONIQUE LE COMPRENANT

(30) Priority: 21.02.2023 KR 20230022747; 30.03.2023 KR 20230042183
(43) Date of publication of application: 23.10.2024
(73) Proprietor: Samsung Electronics Co., Ltd., Suwon-si, Gyeonggi-do 16677 (KR); Molex, LLC, Lisle, IL 60532 (US)
(72) Inventor: YOO, Joon, Suwon-si, Gyeonggi-do 16677 (KR); MUN, Hanseok, Suwon-si, Gyeonggi-do 16677 (KR); YANG, Seyoung, Suwon-si, Gyeonggi-do 16677 (KR); LEE, Kyungho, Suwon-si, Gyeonggi-do 16677 (KR); HAN, Jaeryong, Suwon-si, Gyeonggi-do 16677 (KR); HUR, Jangwon, Suwon-si, Gyeonggi-do 16677 (KR); KANG, Hyongjung, Ansan-si, Gyeonggi-do 15429 (KR); YANG, Inchull, Ansan-si, Gyeonggi-do 15429 (KR)
(74) Representative: Gulde & Partner
(86) International application number: PCT/KR2023/017500
(87) International publication number: WO 2024/177222

(56) References cited:
- CN-A- 107 800 451
- CN-A- 112 688 101
- CN-A- 112 886 296
- CN-Y- 201 061 023
- KR-A- 20160 045 533
- KR-A- 20170 063 163
- KR-A- 20170 086 269
- KR-A- 20170 098 094
- KR-B1- 102 120 399
- US-A1- 2019 348 799
- US-A1- 2020 293 841

## Description

### [Technical Field]

Embodiments of the disclosure relate to a socket for mounting a storage medium tray and/or an electronic device including the socket.

### [Background Art]

The growth of electronics, information, and communication technologies leads to integration of various functions into a single electronic device. For example, smartphones pack the functionalities of a sound player, imaging device, and scheduler, as well as the communication functionality and, on top of that, may implement more various functions by having applications installed thereon. An electronic device may not only execute its equipped applications or stored files but also access, wiredly or wirelessly, a server or another electronic device to receive, in real-time, various pieces of information.

A portable electronic device may include a storage medium, such as a subscriber identification module card (or user authentication module card) or a memory card. Such a storage medium may be built into the electronic device itself, or configured to be easily replaced and/or added by the user. For example, the electronic device may include a tray detachable from the housing, and the storage medium may be coupled to the electronic device while being placed on the tray.

CN 201 061 023 Y describes an electronic card coupler with a detection terminal that features an elastic arm to sense card insertion. This design aims to enhance the coupler's ability to detect card insertion by improving the flexible effect of the detection terminal and reducing the influence of elastic fatigue on the detection mechanism. The detection terminal makes contact with a junction on the shielding casing when no card is present, creating a conductive loop, and this loop is broken when a card is inserted.

US 2020/0293841 A1 describes a multi-card socket for mobile devices, specifically for SIM and SD cards. This design includes a "coupling portion" that interacts with a "sensing portion" to detect card insertion and prevent multiple cards from being inserted simultaneously.

CN 112 886 296 A describes a stacked card holder designed to accommodate multiple cards, like two SIM cards and a TF card, in a compact space. This design utilizes a "movable terminal" and a "static terminal" to form a detection assembly that senses card insertion.

US 2019/348799 A1 describes a card socket for electronic devices with a detection terminal configuration for enhanced card insertion sensing. The design focuses on improving the reliability and accuracy of card detection by utilizing a first and second contact part on the detection terminal that interact with a switch terminal.

The above-described information may be provided as related art for the purpose of helping understanding of the disclosure. No claim or determination is made as to whether any of the foregoing is applicable as background art in relation to the disclosure.

### [Disclosure of Invention]

### [Solution to Problems]

According to an embodiment of the disclosure, a socket for mounting a storage medium tray is defined in appended claim 1.

According to an embodiment of the disclosure, an electronic device is defined in claim 8.

According to embodiments of the invention, in order to improve space efficiency and reduce costs, the space for the tray detection structure is designated and the terminal is not manufactured and assembled separately, but is implemented by using parts already existing in the socket. The direction of insertion of the tray and the direction of operation of the terminal, i.e. the detection structure, are different from each other. It thus becomes possible to prevent damage to the detection terminal due to over-entry of the tray. Also, the location of the tray detection structure is arranged in the center of the receiving space to prevent tray detection failures when inserting a tray. By elastically displacing at least one detection structure when the tray is inserted, a state of electrical contact can be modified, enabling a detection of whether a tray is present in the receiving space or not. The displaceable detection structure may protrude into the receiving space from a wall, e.g. a top wall, a bottom wall or a side wall, which extends substantially parallel to the sliding direction of the tray.

### [Brief Description of Drawings]

The foregoing and other aspects, configurations, and/or advantages of an embodiment of the disclosure will be more apparent from the following detailed description taken in conjunction with the accompanying drawings.
FIG. 1 is a front perspective view illustrating an electronic device according to an embodiment of the disclosure;
FIG. 2 is a perspective view illustrating a rear surface of the electronic device of FIG. 1 according to an embodiment of the disclosure;
FIG. 3 is an exploded perspective view illustrating the electronic device of FIG. 1 according to an embodiment of the disclosure;
FIG. 4 is an exploded perspective view illustrating a portion of an electronic device according to an embodiment of the disclosure;
FIG. 5 is a view illustrating a socket and a tray of an electronic device according to an embodiment of the disclosure;
FIG. 6 is a view illustrating a socket of an electronic device as viewed in direction V1 of FIG. 5 according to an embodiment of the disclosure;
FIG. 7 is a perspective view illustrating a portion of a socket of an electronic device, taken along line C1 of FIG. 5, according to an embodiment of the disclosure;
FIG. 8 is a view illustrating a portion of a socket of an electronic device, taken along line C1 of FIG. 5, before a tray is inserted, according to an embodiment of the disclosure;
FIG. 9 is a view illustrating a portion of a socket of an electronic device, taken along line C1 of FIG. 5, after a tray is inserted, according to an embodiment of the disclosure;
FIG. 10 is a view illustrating a socket of an electronic device according to an embodiment of the disclosure;
FIG. 11 is a perspective view illustrating a state in which a tray is inserted into a socket of an electronic device according to an embodiment of the disclosure;
FIG. 12 is a view illustrating a portion of a socket of an electronic device, taken along line A-A' of FIG. 10, before a tray and a detection terminal contact each other, according to an embodiment of the disclosure;
FIG. 13 is a view illustrating a portion of a socket of an electronic device, taken along line A-A' of FIG. 10, after a tray and a detection terminal contact each other, according to an embodiment of the disclosure;
FIG. 14 is a view illustrating a socket of an electronic device according to an embodiment of the disclosure;
FIG. 15 is an enlarged perspective view illustrating a detection terminal in a socket of an electronic device according to an embodiment of the disclosure;
FIG. 16 is a view illustrating a tray of an electronic device according to an embodiment of the disclosure;
FIG. 17 is a view illustrating a state in which the tray of FIG. 16 is inserted into an inside of a housing or a side structure according to an embodiment of the disclosure;
FIG. 18 is a view illustrating a state in which a head part is rotated in the tray of FIG. 16, according to an embodiment of the disclosure; and
FIG. 19 is a view illustrating a state in which a head part is rotated in a state in which the tray of FIG. 16 is inserted into an inside of a housing or a side structure according to an embodiment of the disclosure.

Throughout the drawings, like reference numerals may be assigned to like parts, components, and/or structures.

### [Mode for the Invention]

To receive a structure, such as a storage medium or a tray, an electronic device may include a separate space and/or a separate component, such as a socket, inside the housing, which may be an obstacle to downsizing the electronic device. Although such obstacles are partially addressed as storage media gradually come in reduced size, the mechanical structure (e.g., push-pull structure or pivoting lever structure) for removing the storage medium or tray from the housing or the structure for detecting the coupling of the tray may still be an obstacle to downsizing the electronic device.

An embodiment of the disclosure aims to address the foregoing issues and/or drawbacks and provide advantages described below, providing a socket easy to downsize and/or an electronic device including the same.

An embodiment of the disclosure may provide a socket downsized and capable of detecting whether a tray is coupled and/or an electronic device including the same.

Objects of the disclosure are not limited to the foregoing, and other unmentioned objects would be apparent to one of ordinary skill in the art from the following description.

The following description taken in conjunction with the accompanying drawings may provide an understanding of various exemplary implementations of the disclosure, including claims. The specific embodiments disclosed in the following description entail various specific details to aid understanding, but are regarded as one of various embodiments. Accordingly, it will be understood by those skilled in the art that various changes and modifications may be made to the various implementations described in the disclosure without departing from the scope of the disclosure. Further, descriptions of well-known functions and configurations may be omitted for clarity and brevity.

The terms and words used in the following description and claims are not limited to the bibliographical meaning, but may be used to clearly and consistently describe an embodiment of the disclosure. Therefore, it will be apparent to those skilled in the art that the following description of various implementations of the disclosure is provided only for the purpose of description, not for the purpose of limiting the disclosure defined as the scope of the claims.

The singular forms "a," "an," and "the" are intended to include the plural forms as well, unless the context clearly indicates otherwise. Thus, as an example, "a component surface" may be interpreted as including one or more of the surfaces of a component.

The electronic device according to embodiment(s) of the disclosure may be one of various types of electronic devices. The electronic devices may include, for example, a portable communication device (e.g., a smartphone), a computer device, a portable multimedia device, a portable medical device, a camera, a wearable device, or a home appliance. The electronic devices according to an embodiment are not limited to those described above.

It should be appreciated that an embodiment of the disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used herein, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

An embodiment of the disclosure may be implemented as software (e.g., the program) including one or more instructions that are stored in a storage medium (e.g., internal memory or external memory) that is readable by a machine (e.g., the electronic device). For example, a processor (e.g., the processor) of the machine (e.g., the electronic device) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The storage medium readable by the machine may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiment(s) of the disclosure may be included and provided in a computer program product. The computer program products may be traded as commodities between sellers and buyers. The computer program product may be distributed in the form of a machine-readable storage medium (e.g., compact disc read only memory (CD-ROM)), or be distributed (e.g., downloaded or uploaded) online via an application store (e.g., Play Store^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to an embodiment, each component (e.g., a module or a program) of the above-described components may include a single entity or multiple entities. Some of the plurality of entities may be separately disposed in different components. According to an embodiment, one or more of the above-described components may be omitted, or one or more other components may be added. Alternatively or Further, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

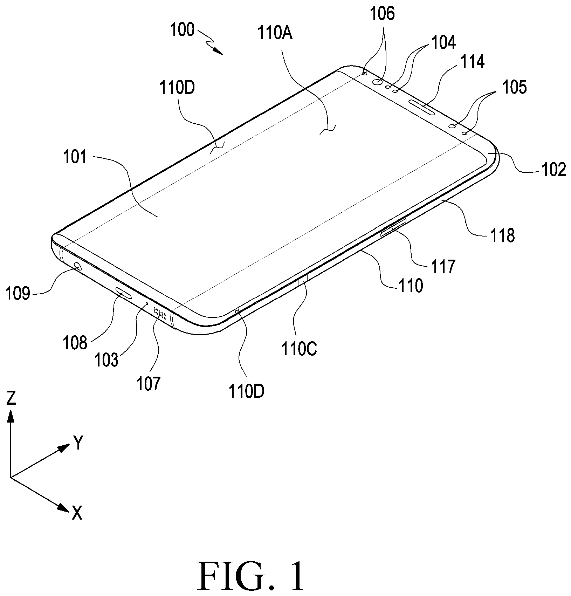

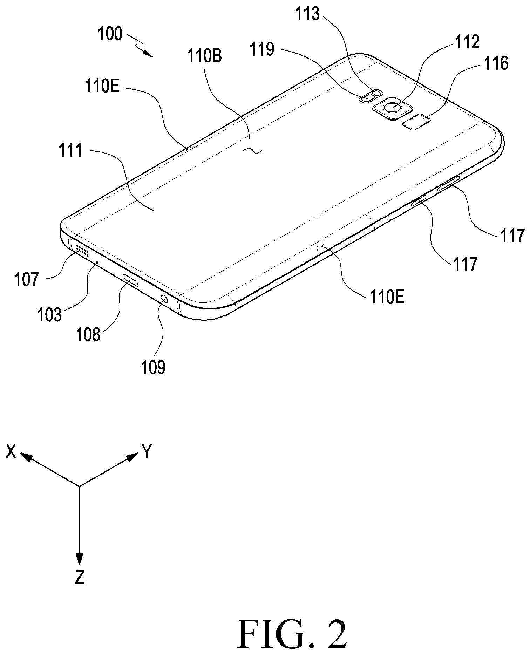

FIG. 1 is a front perspective view illustrating an electronic device according to an embodiment of the disclosure. FIG. 2 is a perspective view illustrating a rear surface of the electronic device of FIG. 1 according to an embodiment of the disclosure;

Referring to FIGS. 1 and 2, according to an embodiment, an electronic device 100 may include a housing 110 with a first (or front) surface 110A, a second (or rear) surface 110B, and a side surface 110C surrounding a space between the first surface 110A and the second surface 110B. In an embodiment (not shown), the housing may denote a structure forming part of the first surface 110A, the second surface 110B, and the side surface 110C of FIG. 1. According to an embodiment, at least part of the first surface 110A may have a substantially transparent front plate 102 (e.g., a glass plate or polymer plate including various coat layers). The second surface 110B may be formed of a substantially opaque rear plate 111. The rear plate 111 may be formed of, e.g., laminated or colored glass, ceramic, polymer, metal (e.g., aluminum, stainless steel (STS), or magnesium), or a combination of at least two thereof. The side surface 110C may be formed by a bezel structure (or a "side structure") 118 that couples to the front plate 102 and the rear plate 111 and includes a metal and/or polymer. According to an embodiment, the rear plate 111 and the side structure 118 may be integrally formed together and include the same material (e.g., a metal, such as aluminum).

In the embodiment illustrated, the front plate 102 may include two first areas 110D, which seamlessly and bendingly extend from the first surface 110A to the rear plate 111, on both the long edges of the front plate 102. In the illustrated embodiment (see FIG. 2), the rear plate 111 has two second areas 110E, which are bent, and seamlessly extend, from the second surface 110B toward the front plate 102, at two opposite long edge ends. According to an embodiment, the front plate 102 (or the rear plate 111) may include only one of the first areas 110D (or the second areas 110E). In an embodiment, some of the first areas 110D or the second areas 110E may not be included. In the above embodiments, when viewed from a side of the electronic device 100, the side structure 118 may have a first thickness (or width) at a side surface which does not include the first areas 110D or the second areas 110E and a second thickness, smaller than the first thickness, at a side surface which includes the first areas 110D or the second areas 110E.

According to an embodiment, the electronic device 100 may include at least one or more of a display 101, audio modules 103, 107, and 114, sensor modules 104, 116, and 119, camera modules 105, 112, and 113, key input devices 117, a light emitting device 106, and connector holes 108 and 109. According to an embodiment, the electronic device 100 may exclude at least one (e.g., the key input device 117 or the light emitting device 106) of the components or may add other components.

According to an embodiment, the display 101 may be exposed through, e.g., a majority portion of the front plate 102. In some embodiments, at least a portion of the display 101 may be exposed through the front plate 102 forming the first surface 110A and the first areas 110D of the side surface 110C. According to an embodiment, the edge of the display 101 may be formed to be substantially the same in shape as an adjacent outer edge of the front plate 102. In an embodiment (not shown), the interval between the outer edge of the display 101 and the outer edge of the front plate 102 may remain substantially even to give a larger area of exposure the display 101.

In an embodiment (not shown), the screen display area of the display 101 may have a recess or opening in a portion thereof, and at least one or more of the audio module 114, sensor module 104, camera module 105, and light emitting device 106 may be aligned with the recess or opening. In an embodiment (not shown), at least one or more of the audio module 114, sensor module 104, camera module 105, fingerprint sensor 116, and light emitting device 106 may be included on the rear surface of the screen display area of the display 101.

In an embodiment (not shown), the display 101 may include at least one of an audio module 114, a sensor module 104, a camera module 105, and a light emitting device 106 on the rear surface of the screen display area (e.g., the first surface 110A and the first areas 110D). For example, the electronic device 100 may have the camera module 105 disposed on the rear surface of at least one of the first surface 110A (e.g., the front surface) and/or the side surface 110C (e.g., the first area 110D) to face the first surface 110A and/or the side surface 110C. For example, the camera module 105 may include an under display camera (UDC) that is not exposed to the screen display area.

In an embodiment (not shown), the display 101 may be disposed to be coupled with, or adjacent, a touch detecting circuit, a pressure sensor capable of measuring the strength (pressure) of touches, and/or a digitizer for detecting a magnetic field-type stylus pen. In some embodiments, at least a portion of the sensor modules 104 and 119, and/or at least a portion of the key input device 117 may be disposed in the first areas 110D and/or the second areas 110E.

In an embodiment (not shown), the display 101 may include a display that is disposed to be slidable and provides a screen (e.g., a screen display area). For example, the screen display area of the electronic device 101 is an area that is visually exposed and enables an image to be output. The electronic device 100 may adjust the screen display area according to movement of a sliding plate (not shown) or movement of the display 101. For example, the electronic device 100 may include a rollable electronic device configured to selectively expand the screen display area as at least a portion (e.g., the housing) of the electronic device 100 is operated to be at least partially slidable. For example, the display 101 may be referred to as a slide-out display or an expandable display.

According to an embodiment, the audio modules 103, 107, and 114 may include a microphone hole 103 and speaker holes 107 and 114. A microphone for acquiring external sounds may be disposed in the microphone hole 103. In some embodiments, a plurality of microphones may be disposed to detect the direction of the sound. The speaker holes 107 and 114 may include an external speaker hole 107 and a phone receiver hole 114. According to an embodiment, the speaker holes 107 and 114 and the microphone hole 103 may be implemented as a single hole, or speakers may be rested without the speaker holes 107 and 114 (e.g., piezo speakers).

According to an embodiment, the sensor modules 104, 116, and 119 may generate an electrical signal or data value corresponding to an internal operating state or external environmental state of the electronic device 100. For example, the sensor modules 104, 116, and 119 may include a first sensor module 104 (e.g., a proximity sensor) and/or a second sensor module (not shown) (e.g., a fingerprint sensor), which is disposed on the first surface 110A of the housing 110, and/or a third sensor module 119 (e.g., a heartrate monitor (HRM) sensor) and/or a fourth sensor module 116 (e.g., a fingerprint sensor) disposed on the second surface 110B of the housing 110. The fingerprint sensor may be disposed on the second surface 110B as well as the first surface 110A (e.g., the display 101) of the housing 110. The electronic device 100 may include a sensor module not shown, e.g., at least one of a gesture sensor, a gyro sensor, a barometric sensor, a magnetic sensor, an acceleration sensor, a grip sensor, a color sensor, an infrared (IR) sensor, a biometric sensor, a temperature sensor, a humidity sensor, or an illuminance sensor.

According to an embodiment, the camera modules 105, 112, and 113 may include a first camera device 105 disposed on the first surface 110A of the electronic device 100, and a second camera device 112 and/or a flash 113 disposed on the second surface 110B. The camera devices 105 and 112 may include one or more lenses, an image sensor, and/or an image signal processor. The flash 113 may include, e.g., a light emitting diode (LED) or a xenon lamp. According to an embodiment, two or more lenses (an infrared (IR) camera, a wide-angle lens, and a telephoto lens) and image sensors may be disposed on one surface of the electronic device 100.

According to an embodiment, the key input device 117 may be disposed on the side surface 110C of the housing 110. In an embodiment, the electronic device 100 may exclude all or some of the above-mentioned key input devices 117 and the excluded key input devices 117 may be implemented in other forms, e.g., as soft keys, on the display 101. According to an embodiment, the key input device may include the sensor module 116 disposed on the second surface 110B of the housing 110.

According to an embodiment, the light emitting device 106 may be disposed on, e.g., the first surface 110A of the housing 110. The light emitting device 106 may provide, e.g., information about the state of the electronic device 100 in the form of light. In an embodiment, the light emitting device 106 may provide a light source that interacts with, e.g., the camera module 105. The light emitting device 106 may include, e.g., a light emitting diode (LED), an infrared (IR) LED, or a xenon lamp.

According to an embodiment, the connector holes 108 and 109 may include, e.g., a first connector hole 108 for receiving a connector (e.g., a universal serial bus (USB) connector) for transmitting or receiving power and/or data to/from an external electronic device and/or a second connector hole (e.g., an earphone jack) 109 for receiving a connector for transmitting or receiving audio signals to/from the external electronic device.

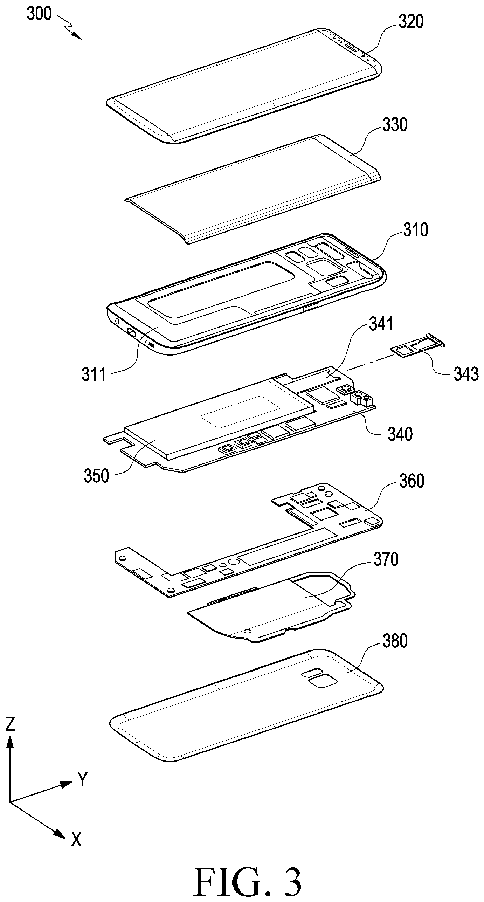

FIG. 3 is an exploded perspective view illustrating the electronic device of FIG. 1 according to an embodiment of the disclosure.

Referring to FIG. 3, an electronic device 300 may include a side structure 310, a first supporting member 311 (e.g., a bracket), a front plate 320, a display 330, a printed circuit board 340 (e.g., a printed circuit board (PCB), a printed board assembly (PBA), a flexible PCB (FPCB), or a rigid-flexible PCB (RFPCB)), a battery 350, a second supporting member 360 (e.g., a rear case), an antenna 370, and a rear plate 380. According to an embodiment, the electronic device 300 may exclude at least one (e.g., the first supporting member 311 or the second supporting member 360) of the components or may add other components. According to an embodiment (not shown), the electronic device 300 may include at least one hinge structure to thereby have a structure in which a housing split into a plurality of areas is folded. For example, according to a change in the state of the hinge structure (e.g., a folded state, an intermediate state, or an unfolded state), the state of the display operatively connected to the housing may change. For example, the first display corresponding to the first housing and the second display corresponding to the second housing may be changed to face each other or to be spaced apart from each other. According to an embodiment, at least one of the components of the electronic device 300 may be the same or similar to at least one of the components of the electronic device 100 of FIG. 1 or 2 and no duplicate description is made below.

According to an embodiment, the first supporting member 311 may be disposed inside the electronic device 300 to be connected with the side structure 310 or integrated with the side structure 310. The first supporting member 311 may be formed of, e.g., a metallic material and/or non-metallic material (e.g., polymer). The display 330 may be joined onto one surface of the first supporting member 311, and the printed circuit board 340 may be joined onto the opposite surface of the first supporting member 311.

According to an embodiment, a processor, memory, and/or an interface may be mounted on the printed circuit board 340. The processor may include one or more of, e.g., a central processing unit, an application processor, a graphic processing device, an image signal processing, a sensor hub processor, or a communication processor. In one embodiment, the processor or communication module may be mounted in the electronic component, such as an integrated circuit chip, and disposed on the printed circuit board 340.

According to an embodiment, the memory may include, e.g., volatile or nonvolatile memory.

According to an embodiment, the interface may include, e.g., a high definition multimedia interface (HDMI), a universal serial bus (USB) interface, a secure digital (SD) card interface, and/or an audio interface. The interface may electrically or physically connect, e.g., the electronic device 300 with an external electronic device and may include a USB connector, an SD card/multimedia card (MMC) connector, or an audio connector.

According to an embodiment, the battery 350 may be a device for supplying power to at least one component of the electronic device 300. The battery 189 may include, e.g., a primary cell which is not rechargeable, a secondary cell which is rechargeable, or a fuel cell. At least a portion of the battery 350 may be disposed on substantially the same plane as the printed circuit board 340. The battery 350 may be integrally or detachably disposed inside the electronic device 300.

According to an embodiment, the antenna 370 may be disposed between the rear plate 380 and the battery 350. The antenna 370 may include, e.g., a near-field communication (NFC) antenna, a wireless charging antenna, and/or a magnetic secure transmission (MST) antenna. The antenna 370 may perform short-range communication with, e.g., an external device or may wirelessly transmit or receive power necessary for charging. In an embodiment of the present invention, an antenna structure may be formed by a portion or combination of the side structure 310 and/or the first supporting member 311.

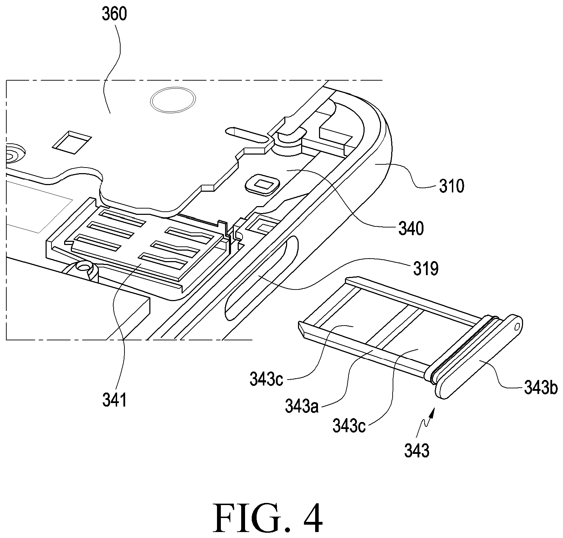

According to an embodiment, the electronic device 300 (e.g., the electronic device 100 of FIGS. 1 and 2) may include the tray 343 and/or the socket 341, so that the user may replace or add a storage medium, such as a subscriber identification module card or a memory card, as necessary. The tray 343 provides a space and/or structure capable of receiving at least one storage medium and may be removably received in the housing (e.g., side structure 310). In an embodiment, the socket 341 may be disposed inside the housing to receive and/or secure at least a portion of the tray 343. In an embodiment, the socket 341 may be mounted on the printed circuit board 340 to be electrically connected to at least some of the electrical/electronic components disposed on the printed circuit board 340. For example, the storage medium(a) disposed on the tray 343 may be electrically connected to the socket 341 and/or to the printed circuit board 340 through the socket 341. The configuration of the tray 343 and/or the socket 341 is described in greater detail with reference to FIG. 4.

FIG. 4 is an exploded perspective view illustrating a portion of an electronic device according to an embodiment of the disclosure.

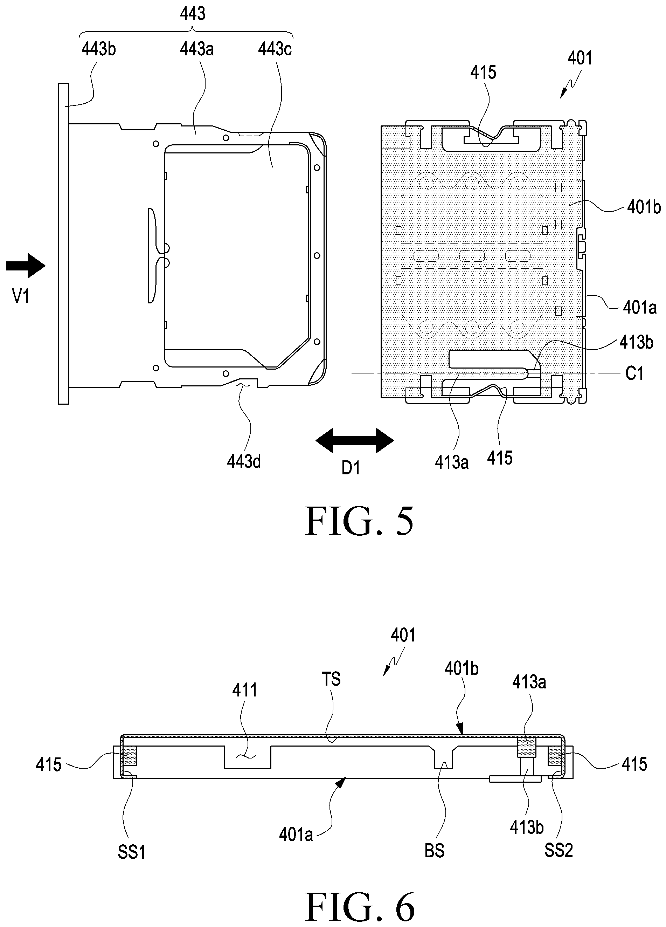

Referring further to FIG. 4, an electronic device 300 may include an opening 319 provided through a side surface (e.g., the side structure 310) of the housing, and the socket 341 may be disposed to be aligned with the opening 319 inside the housing. The socket 341 may be disposed on one surface of the printed circuit board 340 and may be disposed between the printed circuit board 340 and the first supporting member 311 or between the printed circuit board 340 and the second supporting member 360. The tray 343 may receive at least one storage medium and may be inserted into the side structure 310 through the opening 319. The 'storage medium' may include a memory card, such as an SD card, or a subscriber identification module (SIM) card. The socket 341 may provide a receiving space (e.g., the receiving space 411 of FIG. 6) for receiving at least a portion of the tray 343. For example, in a state in which the tray 343 is inserted into the housing, the tray 343 may be received in the socket 341 (e.g., the receiving space 411) to electrically connect the storage medium to the socket 341 or the printed circuit board 340. "Electrically connect the storage medium to the socket 341 or the printed circuit board 340" may be understood as providing an environment in which the processor of the electronic device 300 may apply an electrical signal to the storage medium or read information stored in the storage medium.

According to an embodiment, the tray 343 may include a seating part 343a and a head part 343b. The seating part 343a may have, e.g., a frame shape providing at least one seating area 343c. For example, the seating part 343a may define a space in which the storage medium is substantially disposed or received. In an embodiment, the head part 343b may be a portion that may be disposed at one end of the seating part 343a and is directly handled by the user when the tray 343 is inserted into or separated from the housing (e.g., the side structure 310). In an embodiment, when the tray 343 is inserted into the housing, the head part 343b may be disposed substantially on the opening 319 and at least partially implement a flat or curved surface continuous to an outer surface (e.g., the surface of the side structure 310) of the housing.

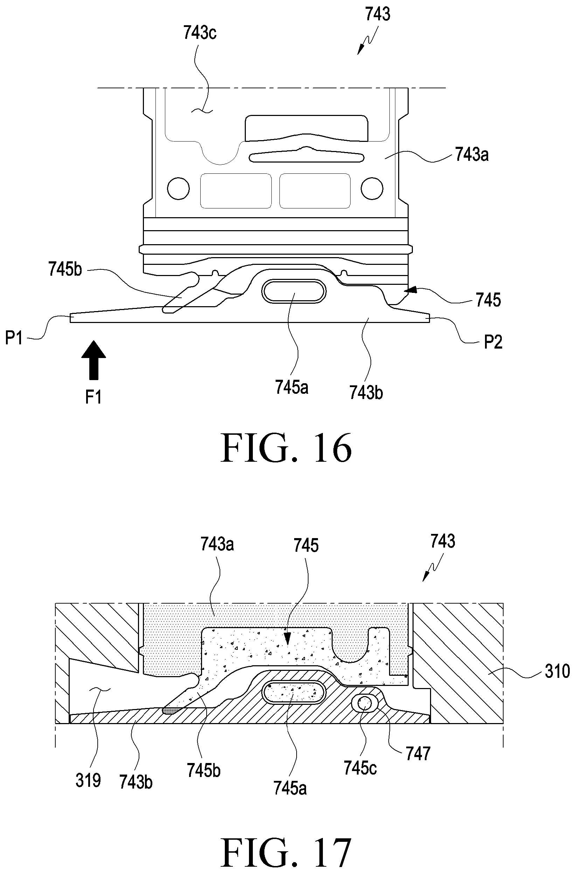

As is described with reference to FIGS. 16 to 19, the head part 343b may be disposed to be rotatable about the seating part 343a. For example, when the tray 343 is inserted into the housing, the head part 343b may implement a flat or curved surface continuous to the outer surface of the housing (e.g., the surface of the side structure 310), and/or may partially protrude from the outer surface of the housing by rotating about the seating part 343a. In an embodiment, when the head part 343b partially protrudes from the outer surface of the housing, the user may pull a portion of the head part 343b to separate the tray 343 from the housing. For example, even if the electronic device 300 or the socket 341 does not include a mechanical structure (e.g., a push-pull structure or a pivoting lever structure) for separating the tray 343, the user may easily separate the tray 343 from the housing. Since it is not necessary to include a mechanical structure (e.g., a push-pull structure or a pivoting lever structure) for separating the tray 343, it may be easy to downsize the electronic device 300 or the socket 341.

It should be noted that in the following detailed description, reference may be made to the electronic devices 100 and 300 of the foregoing embodiments, and components, which may easily be understood through the foregoing embodiments, are assigned the same reference numerals or omitted and a description thereof may be omitted.

FIG. 5 is a view illustrating a socket and a tray of an electronic device according to an embodiment of the disclosure. FIG. 6 is a view illustrating a socket of an electronic device as viewed in direction V1 of FIG. 5 according to an embodiment of the disclosure.

Referring to FIGS. 5 and 6, a tray 443 (e.g., the tray 343 of FIG. 3 or FIG. 4) may include a seating part 443a that provides a seating area 443c and a head part 443b and, in an embodiment, may include at least one support recess 443d formed in a side surface of the seating part 443a. The socket 401 (e.g., the socket 341 of FIG. 3 or FIG. 4) may include a support piece(s) 415 of a leaf spring structure. For example, when the tray 443 is received in the socket 401, a portion of the support piece may be engaged with the support recess and/or may press the side surface of the seating part 443a to support or fix the tray 443 in the state of being received in the socket 401.

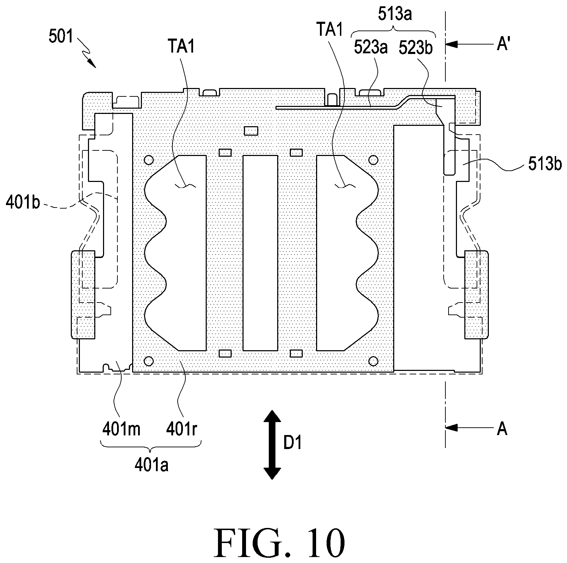

According to an embodiment, the socket 401 may include a lower shell 401a and an upper shell 401b, and the upper shell 401b may be coupled to face the lower shell 401a to form a space (hereinafter, referred to as a "receiving space 411") for receiving the tray 443. Although not shown, the lower shell 401a may provide a bottom surface BS of the receiving space 411 and may include a plurality of contact terminals that electrically contact the storage medium. In an embodiment, the contact terminal(s) may be in direct contact with the storage medium by being exposed or protruding into the receiving space 411 while being partially embedded in the polymer material. These contact terminal(s) may be disposed, e.g., in an area indicated by 'TA1' of FIG. 10.

According to an embodiment, the upper shell 401b may at least partially include an electrically conductive material, and may provide at least some of the sidewalls SS1 and SS2 of the receiving space 411 and/or the upper surface TS of the receiving space 411. For example, the upper shell 401b may be manufactured by processing (e.g., cutting or sheet metal processing) a metal plate, and be coupled to the lower shell 401a to face the lower shell 401a to implement the receiving space 411. In an embodiment, the support piece(s) 415 may be substantially a portion of the upper shell 401b and may be a portion processed to protrude (or bend) from the sidewall(s) SS1 and SS2 to the inside of the receiving space 411.

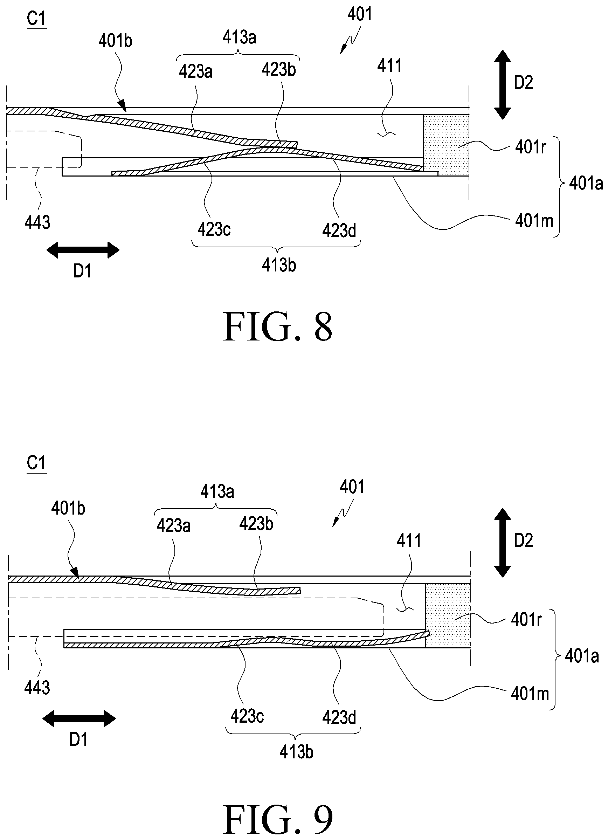

According to an embodiment, the tray 443 may be inserted into or withdrawn from the housing (e.g., the side structure 310 of FIG. 3 or FIG. 4) or the socket 401 along the first direction D1. The 'first direction D1' may be substantially parallel to, e.g., any one of the X-axis direction or the Y-axis direction of FIGS. 1 to 3. In the illustrated embodiment, the first direction D1 may be substantially parallel to the Y-axis direction of FIGS. 1 to 3. The first direction D1 may be, for example, substantially perpendicular or perpendicular to a front surface or a back surface, for example a display area, of the electronic device. In an embodiment described below, the detection structure (e.g., the first detection terminal 413a and the second detection terminal 413b) may be moved or deformed in a second direction (e.g., the second direction D2 of FIG. 8 or FIG. 9) substantially crossing the first direction D1 when contacting the tray 443. The detection structure may accumulate the elastic force by moving or deforming in the second direction D2. The second direction D2 may be, for example, substantially parallel or parallel to a front surface or a back surface, for example a display area, of the electronic device. The second direction D2 may be perpendicular to the first direction D1. The elastic force accumulated in the detection structure may press a portion of the tray 443 in a direction substantially crossing the first direction D1. For example, the detection structure is a structure for detecting whether the tray 443 is received in the socket 401, and may suppress the tray 443 from moving in the first direction D1. When the first direction D1 is substantially parallel to the Y-axis, the second direction D2 may be substantially parallel to the Z-axis direction or the X-axis direction. For example, the second direction D2 may be substantially perpendicular to the first direction D1. However, this is mentioned for simplicity of description, and the second direction D2 may be understood as a direction crossing the first direction D1 or a direction inclined with respect to the first direction D1.

According to an embodiment, the socket 401 may include a detection structure capable of detecting whether the tray 443 is inserted into the receiving space 411, e.g., the first detection terminal 413a and the second detection terminal 413b. For example, the detection terminals 413a and 413b may electrically contact each other or be electrically separated depending on whether the tray 443 is inserted. The electronic device 300 (e.g., the processor) may determine whether the tray 443 is inserted, based on a change in an electrical signal according to whether the detection terminals 413a and 413b contact each other, and may provide an electrical signal to the storage medium or may read information stored in the storage medium when it is determined that the tray 443 is inserted. In the embodiment to be described below, a structure in which the detection terminals 413a and 413b are electrically separated as the tray 443 is inserted may be described as an example. However, the embodiment(s) of the disclosure are not limited thereto, and a structure in which they electrically contact each other when the tray is inserted, and are electrically separated when the tray is separated from the socket depending on the relative positions of the detection terminals 413a and 413b may be implemented.

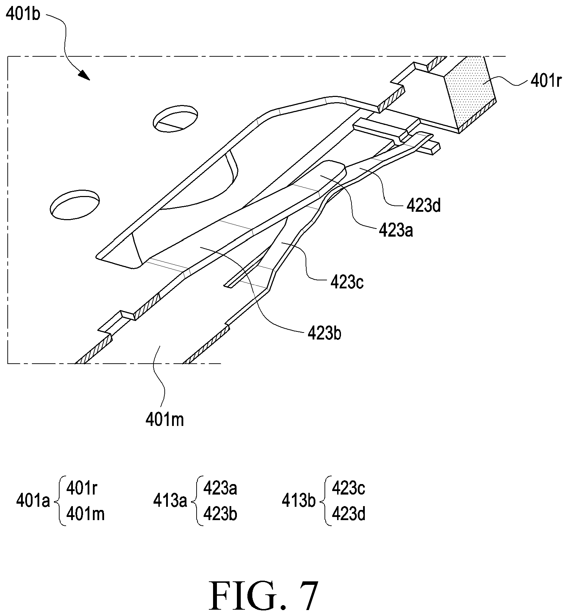

FIG. 7 is a perspective view illustrating a portion of a socket of an electronic device, taken along line C1 of FIG. 5, according to an embodiment of the disclosure.

Referring further to FIG. 7, the first detection terminal 413a may be at least partially disposed between the upper surface TS and the lower surface BS of the receiving space 411, and the second detection terminal 413b may be at least partially provided between the upper surface TS and the lower surface BS of the receiving space 411 or on the lower surface BS of the receiving space 411. As in the illustrated embodiment, in a structure in which the second detection terminal 413b is disposed between the upper surface TS and the lower surface BS of the receiving space 411, as the tray 443 is inserted along the first direction D1, the first detection terminal 413a and/or the second detection terminal 413b may be electrically separated while being deformed in a second direction (e.g., the second direction D2 of FIG. 8 or FIG. 9) crossing the first direction D1. For example, the first detection terminal 413a and the second detection terminal 413b may be deformed or moved by contacting the tray 443. In a structure in which the second detection terminal 413b is disposed on the lower surface BS, as the tray 443 is inserted, the first detection terminal 413b may be deformed and electrically separated from the second detection terminal 413b, and the second detection terminal 413b may remain in a substantially fixed position. In other words, the first detection terminal 413a and the second detection terminal 413b may be electrically in contact when no tray 443 is present in the receiving space 411. The electrical contact between the first detection terminal 413a and the second detection terminal 413b may be disconnected when a tray 443 is present in the receiving space 411.

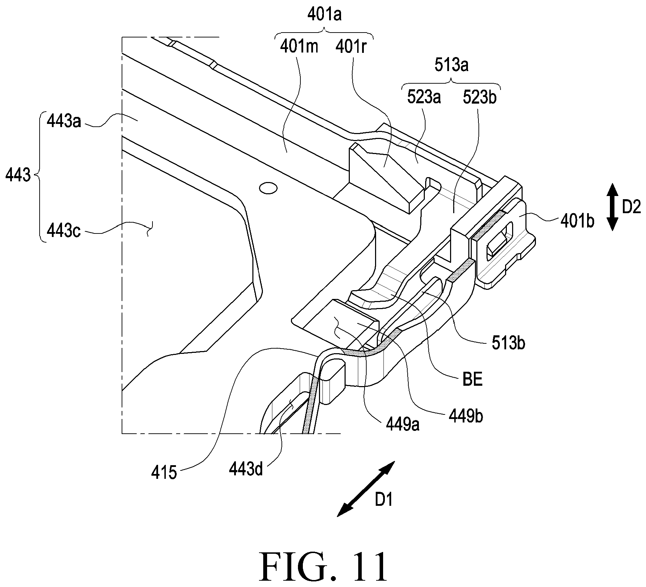

According to an embodiment, the sum of the displacements of the first detection terminal 413a and the displacement of the second detection terminal 413b according to the contact with the tray 443 may substantially correspond to the thickness of the tray 443 (e.g., the seating part 443a). For example, the structure in which the first detection terminal 413a and the second detection terminal 413b are deformed may reduce the load applied to the first detection terminal 413a due to the deformation as compared to the structure in which the second detection terminal 413b maintains a fixed position. In an embodiment, regardless of whether the structure is a structure in which the second detection terminal 413b is fixed, a portion of the tray 443 that is designed to make contact with a detection structure has a smaller thickness than another portion of the tray 443 which is designed not to make contact with a detection structure, so that the load applied to the first detection terminal 413a and/or the second detection terminal 413b may be reduced due to deformation. This will be further described with reference to the embodiments illustrated in FIGS. 11 to 13.

According to an embodiment, the above-described detection structure (e.g., the first detection terminal 413a and/or the second detection terminal 413b) may be disposed within a range of a section in which the tray 443 moves when the tray 443 enters the receiving space 411 or is separated from the receiving space 411. For example, when the tray 443 moves in the receiving space 411, at least a portion of the first detection terminal 413a and/or the second detection terminal 413b may be in sliding contact with the tray 443. In an embodiment, in the operation in which the tray 443 is inserted, the detection structure may not substantially contact the storage medium. For example, in the operation in which the tray 443 is inserted, the detection structure may be in contact with a frame structure surrounding the seating area 443c in the seating part 443a. Referring to the structure illustrated in FIG. 5, when the tray 443 enters the receiving space 411, the first detection terminal 413a and/or the second detection terminal 413b may be electrically separated from each other while slidingly contacting the upper surface and/or the lower surface (e.g., the edge of the seating part 443a) of the tray 443 (e.g., the seating part 443a). In an embodiment, an edge of the seating part 443a and a portion of the receiving space 411 corresponding to the edge of the seating part 443a may be referred to as a "tray guide structure". For example, the tray 443 may slide along the first direction D1 while being guided by the tray guide structure and may be inserted into or separated from the socket 401. The above-described detection structure (e.g., the first detection terminal 413a and/or the second detection terminal 413b) is substantially disposed on the tray guide structure, and thus may be in sliding contact with a portion of the tray 443 (e.g., the edge of the seating part 443a).

According to an embodiment, the first detection terminal 413a may extend from the upper shell 401b and may be disposed at least partially in parallel with the first direction D1. For example, the first detection terminal 413a may be understood as being substantially a portion of the upper shell 401b and including an electrically conductive material. In an embodiment, the first detection terminal 413a may extend substantially parallel to the first direction D1 when viewed in the plan view of FIG. 5. In an embodiment, the first detection terminal 413a may include a first inclined portion 423a and/or a second inclined portion 423b. When viewed in the plan view of FIG. 5, the first inclined portion 423a may extend from the upper shell 401b and may be disposed side by side with or in parallel with the first direction D1. According to an embodiment, the first inclined portion 423a may extend to be inclined with respect to the upper surface TS of the receiving space 411. For example, the first inclined portion 423a may extend from the upper surface toward the inside of the receiving space 411 while being substantially parallel to the first direction D1. In an embodiment, when it is described that one end portion of the first inclined portion 423a is in contact with the upper surface TS of the receiving space 411, it may be understood that the other end portion of the first inclined portion 423a is disposed in the receiving space 411. In an embodiment, the second inclined portion 423b may extend from the other end portion of the first inclined portion 423a to be inclined with respect to the first inclined portion 423a and/or with respect to the upper surface TS of the receiving space 411. When viewed in the plan view of FIG. 5, the second inclined portion 423b may be disposed substantially parallel to the first direction D1.

According to an embodiment, the first detection terminal 413a may be substantially parallel to the first direction D1 while at least a portion thereof protrudes inward of the receiving space 411. The portion protruding from the first detection terminal 413a toward the inside of the receiving space 411 may be a portion in which the first inclined portion 423a and the second inclined portion 423b are substantially connected. When the tray 443 is inserted into the receiving space 411 or separated from the socket 401, the first detection terminal 413a may be in sliding contact with the tray 443 at, at least, a portion (e.g., the portion where the first inclined portion 423a and the second inclined portion 423b are connected) of the first inclined portion 423a or the second inclined portion 423b. While the tray 443 is inserted into the receiving space 411, the tray 443 may apply a force substantially perpendicular to the sliding direction of the tray (e.g. the first direction D1) onto the first detection terminal 413a or a portion of the first detection terminal 413a, e.g. the first inclined portion 423a and/or the second inclined portion 423b. The applied force may push the respective portion or portions of the first detection terminal 413a such that a movement of the respective portion or portions of the first detection terminal 413a is induced. The first detection terminal 413a may thus be moved to substantially or completely leave the receiving space 411.

When the tray 443 is separated from the receiving space 411, the elastic force accumulated in the first detection terminal 413a may act as a restoring force, and thus the first detection terminal 413a may be in electrical contact with the second detection terminal 413b at the portion where the first inclined portion 423a and the second inclined portion 423b are connected.

According to an embodiment, the lower shell 401a may include electrically conductive structure(s) 401m and insulating structure(s) 401r. For example, a plurality of metal pieces provided as the electrically conductive structure 401m may be at least partially buried in a molded synthetic resin product provided as the insulating structure 401r. 'At least partially buried' may mean that the insulating structure 401r may be manufactured while receiving or fixing the electrically conductive structure 401m by insert injection molding. The plurality of metal pieces may include, e.g., contact terminals and/or the second detection terminal 413b to be in electrical contact with the storage medium. In an embodiment, the electrically conductive structure 401m may be manufactured by processing a metal plate in a similar manner to the upper shell 401b.

According to an embodiment, the second detection terminal 413b may substantially include an electrically conductive material as a portion of the lower shell 401a (e.g., the electrically conductive structure 401m). In an embodiment, when viewed in the plan view of FIG. 5, the second detection terminal 413b may at least partially extend in parallel (e.g., substantially parallel) with the first direction D1. In an embodiment, the second detection terminal 413b may include a third inclined portion 423c and/or a fourth inclined portion 423d. When viewed in the plan view of FIG. 5, the third inclined portion 423c may extend from the electrically conductive structure 401m and may be disposed side by side with or in parallel with the first direction D1. According to an embodiment, the third inclined portion 423c may extend to be inclined with respect to the lower surface BS of the receiving space 411. For example, the third inclined portion 423c may extend from the lower surface BS toward the inside of the receiving space 411 while being substantially parallel to the first direction D1. In an embodiment, when it is described that one end portion of the third inclined portion 423c is in contact with the lower surface BS of the receiving space 411, it may be understood that the other end portion of the third inclined portion 423c is disposed in the receiving space 411. In an embodiment, the fourth inclined portion 423d may extend from the other end portion of the third inclined portion 423c to be inclined with respect to the third inclined portion 423c or the lower surface BS of the receiving space 411. When viewed in the plan view of FIG. 5, the fourth inclined portion 423d may be disposed substantially parallel to the first direction D1. While the tray 443 is inserted into the receiving space 411, the tray 443 may apply a force substantially perpendicular to the sliding direction of the tray (e.g. the first direction D1) onto the second detection terminal 413b or a portion of the second detection terminal 413b, e.g. the third inclined portion 423c and/or the fourth inclined portion 423d. The applied force may push the respective portion or portions of the second detection terminal 413b such that a movement of the respective portion or portions of the second detection terminal 413d is induced. The second detection terminal 413b may thus be moved to substantially or completely leave the receiving space 411.

According to an embodiment, the second detection terminal 413b may be substantially parallel to the first direction D1 while at least a portion thereof protrudes inward of the receiving space 411. The portion protruding inward of the receiving space 411 may be substantially a portion where the third inclined portion 423c and the fourth inclined portion 423d are connected. When the tray 443 is inserted into the receiving space 411 or separated from the socket 401, the second detection terminal 413b may be at least partially in sliding contact with the tray 443. For example, when the tray 443 slides in the socket 401, the second detection terminal 413b may slidingly contact the tray 443 at the portion where the third inclined portion 423c and the fourth inclined portion 423d are connected. When the tray 443 is separated from the receiving space, the elastic force accumulated in the second detection terminal 413b may act, and thus the second detection terminal 413b may be in electrical contact with the first detection terminal 413a at the portion where the third inclined portion 423c and the fourth inclined portion 423d are connected.

An operation of inserting the tray 443 into the socket 401 including the detection structure of FIG. 7 will be further described with reference to FIGS. 8 and 9.

FIG. 8 is a view illustrating a portion of a socket of an electronic device, taken along line C1 of FIG. 5, before a tray is inserted, according to an embodiment of the disclosure. FIG. 9 is a view illustrating a portion of a socket of an electronic device, taken along line C1 of FIG. 5, after a tray is inserted, according to an embodiment of the disclosure.

Referring to FIGS. 8 and 9, until before the tray 443 reaches the position where the detection structure is disposed, the first detection terminal 413a and the second detection terminal 413b may remain in electrical contact. 'Before the tray 443 reaches the position where the detection structure is disposed' may be understood as including a state in which the tray 443 is positioned outside the side structure (e.g., the side structure 310 of FIG. 4). In the electrical contact state, an electrical signal may be transmitted between the first detection terminal 413a and the second detection terminal 413b. For example, the electronic device 300 (e.g., the processor) may determine that the tray 443 is not yet mounted on the socket 401, based on an electrical signal being able to be transferred between the first detection terminal 413a and the second detection terminal 413b.

According to an embodiment, the tray 443 may be in sliding contact with the first detection terminal 413a and/or the second detection terminal 413b from a point in time when the socket 401 reaches the position corresponding to the detection structure in the inside (e.g., the receiving space 411) of the socket 401. In an embodiment, the tray 443 may further enter the socket 401 while forming a gap between the first detection terminal 413a and the second detection terminal 413b. 'A gap is formed between the first detection terminal 413a and the second detection terminal 413b' may be understood as an operation of electrically separating the first detection terminal 413a and the second detection terminal 413b. For example, when the tray 443 is inserted along the first direction D1 and contacts the detection structure, the first detection terminal 413a and/or the second detection terminal 413b may be moved or deformed in the second direction D2. In the illustrated embodiment, when the first direction D1 is substantially parallel to the Y-axis of FIGS. 1 to 3, the second direction D2 may be substantially parallel to the Z-axis direction of FIGS. 1 to 3.

According to an embodiment, as the first detection terminal 413a and the second detection terminal 413b are electrically separated, it may be no longer possible to transfer an electrical signal between the first detection terminal 413a and the second detection terminal 413b. In an embodiment, when it is detected that it is impossible to transfer an electrical signal between the first detection terminal 413a and the second detection terminal 413b, the electronic device 300 may determine that the tray 443 is mounted on the socket 401. 'It is determined that the tray 443 is mounted on the socket 401' may be understood as the electronic device 300 (e.g., the processor) applying an electrical signal to the storage medium or reading information stored in the storage medium. In an embodiment, the electronic device 300 may determine that the tray 443 is mounted on the socket 401, a designated time after the point in time when it is detected that the transfer of an electrical signal is impossible. For example, since there may be a difference between a point in time when the first detection terminal 413a and the second detection terminal 413b are electrically separated and a point in time when the storage medium is connected to the contact terminal(s), the electronic device 300 may determine whether the tray 443 is mounted later than a point in time when it is detected that it is impossible to transfer an electrical signal.

In the illustrated embodiment, a structure in which the first detection terminal 413a and the second detection terminal 413b are moved or deformed is illustrated, but it should be noted that the embodiment(s) of the disclosure are not limited thereto. For example, when the inclination angle of the first detection terminal 413a (e.g., the first inclined portion 423a) with respect to the upper shell 401b increases, the second detection terminal 413b may be disposed to be fixed on substantially the same plane as the electrically conductive structure 401m. In an embodiment, when the inclination angle of the second detection terminal 413b (e.g., the third inclined portion 423c) with respect to the electrically conductive structure 401m increases, the first detection terminal 413a may be disposed to be fixed on substantially the same plane (e.g., the upper surface TS) as the upper shell 401b. For example, when any one of the first detection terminal 413a and the second detection terminal 413b is disposed in a fixed state, the other one of the first detection terminal 413a and the second detection terminal 413b may contact the tray 443 and move or deform.

Although not shown, the second detection terminal 413b may be fixedly disposed at a position adjacent to the upper shell 401b (e.g., on the upper surface TS). For example, as the first detection terminal 413a (e.g., the second inclined portion 423b) contacts the tray 443, the first detection terminal 413a (e.g., the second inclined portion 423b) may be moved or deformed in a direction of contacting the second detection terminal 413b on the upper surface TS. In an embodiment, the first detection terminal 413a may be fixedly disposed under the second detection terminal 413b (e.g., on the lower surface BS) and, as moving while contacting the tray 443, the second detection terminal 413b may contact the first detection terminal 413a on the lower surface BS. In an embodiment in which the first detection terminal 413a and the second detection terminal 413b are moved to come into electrical contact by contact with the tray 443 as described above, the electronic device 300 (e.g., the processor) may determine that the tray 443 is mounted on the socket 401, based on a state in which an electrical signal may be transferred. For example, it should be noted that in implementing a structure in which the electrical contact state and the electrical separation state are switched, the illustrated embodiment(s) partially exemplifies a structure in which the detection terminal(s) 413a and 413b are moved or deformed in a direction different from the first direction D1 by contact with the tray 443, and the embodiment(s) of the disclosure are not limited to the illustrated structure.

In the embodiments to be described below, the components that may be easily understood through the preceding embodiments may be denoted by the same reference numerals or may be omitted, and the detailed description thereof may also be omitted. The configuration of the above-described embodiment(s) and/or the configuration of the embodiment(s) to be described below may be selectively combined to implement additional embodiments.

FIG. 10 is a view illustrating a socket of an electronic device according to an embodiment of the disclosure. FIG. 11 is a perspective view illustrating a state in which a tray is inserted into a socket of an electronic device according to an embodiment of the disclosure.

The area indicated by 'TA1' of FIG. 10 may illustrate an area in which contact terminals to be connected to the storage medium are disposed, as described above. FIG. 11 is a view illustrating a state in which the tray 443 is not sufficiently received in the socket 501 (e.g., the socket 341 of FIG. 4). In this case, the support piece 415 may interfere with the tray 443 (e.g., the seating part 443a) to move or deform outward. For example, it should be noted that in FIG. 11, the support piece 415 is in a position or shape of interfering with the tray 443 but before interfering with the tray 443. In the operation in which the tray 443 is inserted, the support piece 415 may be moved or deformed to the outside by interfering with the tray 443, and in a state in which the tray 443 is sufficiently received in the socket 501, the support piece 415 may be positioned to be substantially engaged with the support recess 443d while being restored to the shape illustrated in FIG. 11.

Referring to FIGS. 10 and 11, the socket 501 and/or the detection structure (e.g., the first detection terminal 513a and the second detection terminal 513b) may include a first detection terminal 513a disposed on the lower shell 401a and a second detection terminal 513b disposed as a portion (e.g., the electrically conductive structure 401m) of the lower shell 401a. In an embodiment, the first detection terminal 513a may include a plate-shaped fixing portion 523a and a plate-shaped extension 523b extending from the fixing portion 523a. The extension 523b is a portion bent in a direction inclined or substantially perpendicular to the fixing portion 523a, and when the fixing portion 523a is aligned to face the tray 443 in the first direction D1, the extension 523b may be disposed substantially parallel to the first direction D1. In an embodiment, the fixing portion 523a may be aligned in a direction substantially perpendicular to the upper surface TS or the lower surface BS of the receiving space (e.g., the receiving space 411 of FIG. 6), and the extension 523b may be disposed substantially side by side with (substantially parallel to) the upper surface TS or the lower surface BS of the receiving space 411.

According to an embodiment, the fixing portion 523a may be buried or assembled in the lower shell 401a, e.g., the insulating structure 401r. 'Buried in the insulating structure 401r' may be understood as, e.g., at least a portion of the fixing portion 523a being surrounded by the insulating structure 401r or being substantially fixed in the insulating structure 401r while simultaneously forming the insulating structure 401r as the first detection terminal 513a is placed in the molds before the molten resin is injected when manufacturing the insulating structure 401r by injection molding.

According to an embodiment, when the fixing portion 523a is disposed in the lower shell 401a, the extension 523b may be disposed in a space between the upper shell 401b (e.g., the upper surface TS of the receiving space 411) and the lower shell 401a (e.g., the lower surface BS of the receiving space 411 or the second detection terminal 513b). In an embodiment, an end portion (hereinafter, referred to as the 'bend BE') of the extension 523b, which is far from the fixing portion 523a, may be shaped to be at least partially bent toward the lower surface BS of the receiving space 411 or the second detection terminal 513b. The end portion may have the shape of a protrusion. The end portion may comprise one, two, or more curved or bent surfaces. For example, the extension 523b may be disposed substantially parallel to the upper surface TS or the lower surface BS of the receiving space 411, and at least the bend BE may be substantially in electrical contact with the second detection terminal 513b when no external force is applied.

As mentioned above, any one of the first detection terminal 513a and the second detection terminal 513b may be disposed in a fixed state, and in the embodiment of FIGS. 10 and 11, the second detection terminal 513b may be disposed in a fixed state while being a portion of the lower shell 401a (e.g., the electrically conductive structure 401m). In an embodiment, the second detection terminal 513b may be electrically insulated from another portion of the electrically conductive structure 401m and may be mechanically connected or coupled to another portion of the electrically conductive structure 401m by the insulating structure 401r. In an embodiment not illustrated, the second detection terminal 513b may be disposed in a fixed state while being a portion of the upper shell 401b. In this case, the bend BE of the first detection terminal 513a may be manufactured to face the upper shell 401b (e.g., the upper surface TS of FIG. 6).

According to an embodiment, the first detection terminal 513a and/or the second detection terminal 513b may be substantially disposed on the tray guide structure described above, and thus, as the tray 443 is inserted, the first detection terminal 513a and/or the second detection terminal 513b may be in sliding contact with the edge (e.g., the seating part 443a) of the tray 443. For example, when the tray 443 is inserted into the socket 501, a portion of the edge of the tray 443 may be disposed adjacent to or overlapping the first detection terminal 513a. In an embodiment, when the tray 443 is inserted into the socket 501, a portion of the edge of the tray 443 may be disposed substantially between the first detection terminal 513a (e.g., the bend BE) and the second detection terminal 513b.

According to an embodiment, in a structure in which one of the first detection terminal 513a and the second detection terminal 513b is disposed in a fixed state, a portion of the tray 443 may have a smaller thickness than the other portion. For example, the tray 443 may have a thickness smaller than the remaining portion in a portion that interferes with or contacts the first detection terminal 513a or the second detection terminal 513b. Accordingly, the load applied when the first detection terminal 513a or the second detection terminal 513b is deformed due to interference or contact with the tray 443 may be reduced. In an embodiment, the tray 443 may include an avoidance recess 449a provided in a portion in contact with the first detection terminal 513a or the second detection terminal 513b, and an interference piece 449b provided on the avoidance recess 449a. For example, the avoidance recess 449a may be recessed from the upper surface of the tray 443 (e.g., the seating part 443a), and the interference piece 449b may provide at least a portion of the bottom of the avoidance recess 449a. In an embodiment, the sum of the thickness of the interference piece 449b and the depth of the avoidance recess 449a may be substantially the same as the thickness of the seating part 443a.

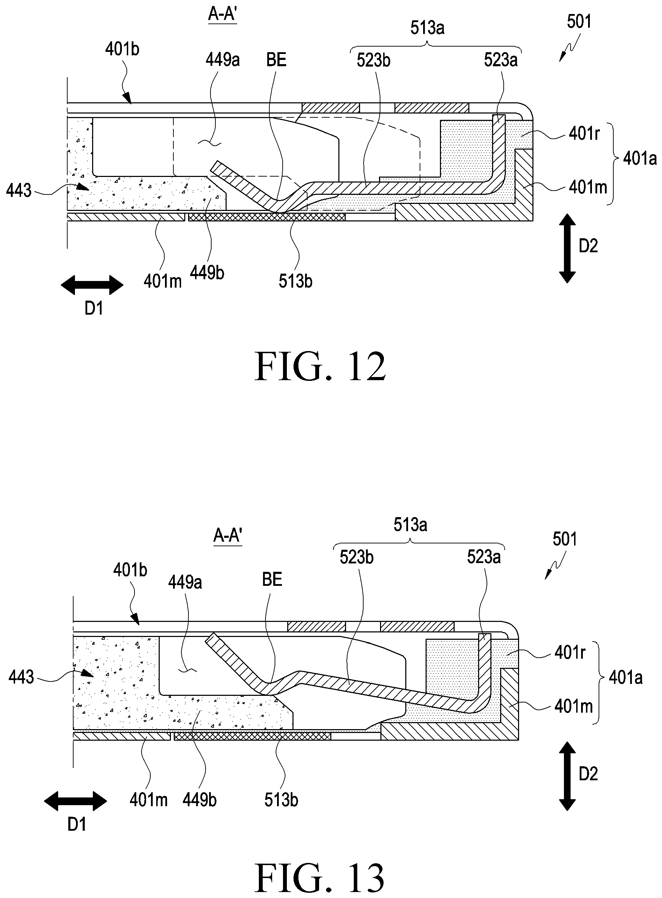

According to an embodiment, when the tray 443 is sufficiently received in the socket 501 along the first direction D1, the interference piece 449b may enter between the first detection terminal 513a and the second detection terminal 513b, and thus the first detection terminal 513a may be electrically separated from the second detection terminal 513b. Here, 'the first detection terminal 513a is electrically separated from the second detection terminal 513b' may refer to the second detection terminal 513b remaining in a fixed state while the first detection terminal 513a is moved or deformed in the second direction D2 crossing the first direction D1 by contacting the interference piece 449b. The first detection terminal 513a and/or the second detection terminal 513b may be disposed in an area opposite of an opening of the receiving space. In other words, the first detection terminal 513a and/or the second detection terminal 513b may be arranged such that, when the tray 443 is introduced into the receiving space, the tray 443 does not mechanically interact with the first detection terminal 513a and/or the second detection terminal 513b for a large portion of the movement, e.g. for at least 80% or at least 90% of the movement. It may such be made sure that the presence of a storage medium is only detected when the storage medium is fully inserted into the receiving space. The operation of the detection structure will be further described with reference to FIGS. 12 and 13.

FIG. 12 is a view illustrating a portion of a socket of an electronic device, taken along line A-A' of FIG. 10, before a tray and a detection terminal contact each other, according to an embodiment of the disclosure. FIG. 13 is a view illustrating a portion of a socket of an electronic device, taken along line A-A' of FIG. 10, after a tray and a detection terminal contact each other, according to an embodiment of the disclosure.

Referring further to FIGS. 12 and 13, even if the tray 443 is inserted into the socket 501 along the first direction D1, the first detection terminal 513a may be in electrical contact with the second detection terminal 513b until the interference piece 449b reaches the first detection terminal 513a (e.g., the bend BE). As the tray 443 is further inserted into the socket 501 along the first direction D1, the interference piece 449b may interfere with the first detection terminal 513a. When interfering with the interference piece 449b, the first detection terminal 513a, e.g., the bend BE, may be substantially disposed on the avoidance recess 449a. 'The first detection terminal 513a is disposed adjacent to or overlapping the tray 443' as mentioned above may refer to a state in which the first detection terminal 513a is at least partially received in the avoidance recess 449a to contact the interference piece 449b.

According to an embodiment, as the tray 443 is further inserted into the socket 501 along the first direction D1 from the point in time when the first detection terminal 513a and the interference piece 449b come into contact with each other, the interference piece 449b may enter between the first detection terminal 513a and the second detection terminal 513b, and the first detection terminal 513a may be moved or deformed in the second direction D2 to be electrically separated from the second detection terminal 513b. The operation in which the electronic device 300 (e.g., the processor) determines whether the tray 443 and/or the storage medium is inserted, based on the electrical contact or separation between the first detection terminal 513a and the second detection terminal 513b may be easily understood through the preceding embodiments.

According to an embodiment, the elastic force accumulated in the extension 523b while the first detection terminal 513a is deformed may be understood as a load applied to the first detection terminal 513a, and/or may be understood as a force for pressing the interference piece 449b (or the tray 443) in the second direction D2. First detection terminal 513a and/or second detection terminal 513b may therefore be designed in the manner of a spring. For example, in the state of being in contact with the interference piece 449b, the first detection terminal 513a may press the tray 443 to keep the tray 443 at the current position in the stationary state. In an embodiment, as mentioned above, the thickness of the interference piece 449b may be smaller than the thickness of the other portion of the tray 443. For example, even if the second detection terminal 513b is disposed in a fixed state and the first detection terminal 513a is deformed by contacting the interference piece 449b, the degree of deformation may be less than the actual thickness of the tray 443. Accordingly, the avoidance recess 449a and/or the interference piece 449b may reduce the load that is a target for detection by the detection structure (e.g., the first detection terminal 513a and the second detection terminal 513b) and may be generated in the detecting operation. In an embodiment, as the interference piece 449b is pressed by the first detection terminal 513a, the tray 443 may be stably maintained or supported while being disposed inside the socket 501.

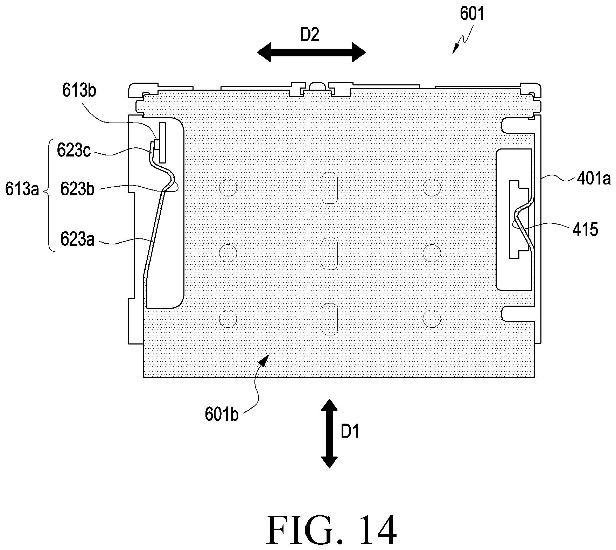

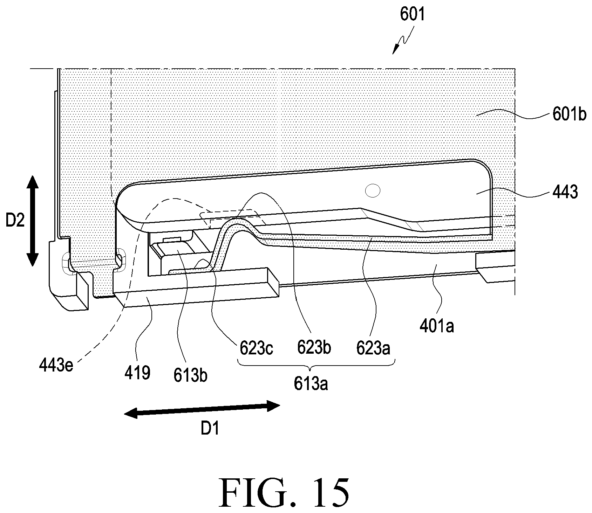

In the above-described embodiments, when the direction (e.g., the first direction D1) in which the tray 443 is inserted is substantially parallel to the Y-axis of FIGS. 1 to 3, the second direction D2 may be substantially parallel to the Z-axis of FIGS. 1 to 3. However, the embodiment(s) of the disclosure are not limited thereto, and when the inserted direction (e.g., the first direction D1) is substantially parallel to the Y axis of FIGS. 1 to 3, the second direction D2 may be substantially parallel to the X axis of FIGS. 1 to 3. For example, the insertion direction of the tray 443 and the movement (or deformation) direction of the detection structure may be substantially implemented in the XY plane of FIGS. 1 to 3. A structure in which the first direction and the second direction are substantially parallel to the XY plane of FIGS. 1 to 3 is described with reference to FIGS. 14 and 15.

FIG. 14 is a view illustrating a socket of an electronic device according to an embodiment of the disclosure. FIG. 15 is an enlarged perspective view illustrating a detection terminal in a socket of an electronic device according to an embodiment of the disclosure.

Referring to FIGS. 14 and 15, a socket 601 (e.g., the socket 341 of FIG. 4) may include a first detection terminal 613a protruding inward of the receiving space 411 from a sidewall (e.g., the sidewall(s) SS1 and SS2 of FIG. 6) of a receiving space (e.g., the receiving space 411 of FIG. 6), and a second detection terminal 613b disposed inside the socket 601 to correspond to the first detection terminal 613a. The second detection terminal 613b may be disposed, e.g., in a fixed state on the socket 601, and the first detection terminal 613a may be disposed to move or deform while slidingly contacting a side surface of the tray 443 (e.g., the seating part 443a of FIG. 5). In an embodiment, the first detection terminal 613a may extend from the upper shell 601b to be inclined with respect to the sidewall(s) SS1 and SS2. For example, when one end of the first detection terminal 613a is directly connected to the upper shell 601b, a portion of the first detection terminal 613a may be disposed in the receiving space 411. 'The first detection terminal 613a slidingly contacts the side surface of the tray 443' as mentioned above may be understood as the first detection terminal 613a being substantially disposed on the above-described tray guide structure.

According to an embodiment, the socket 601 may include a stopper wall 419 provided in the lower shell 401a (or the upper shell 601b). The stopper wall 419 may be disposed to substantially face the second detection terminal 613b. In an embodiment, the first detection terminal 613a may be at least partially disposed between the second detection terminal 613b and the stopper wall 419. For example, a range in which the first detection terminal 613a may be moved or deformed may be defined by the second detection terminal 613b and the stopper wall 419.

According to an embodiment, the first detection terminal 613a may include an extension 623a, an interference portion 623b, and/or a contact portion 623c. The extension 623a may extend, e.g., to be inclined with respect to the first direction D1 from the upper shell 601b toward the inside of the receiving space 411. The inclination angle of the extension 623a with respect to the first direction D1 may be within about 15 degrees. For example, the inclination angle of the extension 623a with respect to the first direction D1 may be within 20 degrees, within 15 degrees or within 10 degrees. In an embodiment, when the first detection terminal 613a (e.g., the interference portion 623b) contacts the tray 443, the extension 623a may be deformed to accumulate an elastic force. The elastic force accumulated in the extension 623a may be understood as the 'load applied to the first detection terminal 613a due to deformation' as mentioned above. In an embodiment, the elastic force accumulated in the extension 623a may be understood as the 'force pressing the tray 443' as mentioned above.

According to an embodiment, the interference portion 623b is a portion substantially in contact with the tray 443 (e.g., a side surface of the tray 443 or a side surface of the seating part 443a) and may be bent in a curved shape. For example, the interference portion 623b may be provided at an end portion of the extension 623a to be disposed inside the receiving space 411 (e.g., on the tray guide structure). Accordingly, when the tray 443 is inserted, the interference portion 623b may move outward of the receiving space 411 in the second direction D2 (e.g., the X-axis direction of FIGS. 1 to 3), and the extension 623a may accumulate an elastic force while allowing or guiding the movement of the interference portion 623b. In an embodiment, the contact portion 623c may be provided at an end portion of the interference portion 623b and may be disposed to substantially face the second detection terminal 613b. For example, at least the contact portion 623c of the first detection terminal 613a may be disposed between the second detection terminal 613b and the stopper wall 419.

In the illustrated embodiment, when the tray 443 is not inserted or when the interference portion 623b is not in contact with the tray 443, an end portion (e.g., the contact portion 623c) of the first detection terminal 613a may substantially be in electrical contact with the second detection terminal 613b. As the tray 443 is inserted into the socket 601 and the interference portion 623b moves, the contact portion 623c may be electrically separated from the second detection terminal 613b. For example, the electronic device 300 (e.g., the processor) may determine whether the tray 443 and/or the storage medium is inserted, based on electrical contact or separation between the first detection terminal 613a and the second detection terminal 613b. In an embodiment not illustrated, when the tray 443 is inserted into the socket 601, the second detection terminal 613b may be disposed at a position in contact with the first detection terminal 613a. For example, in the above-described embodiment, a configuration in which the detection terminals 613a and 613b are electrically separated in a state in which the tray 443 is inserted into the socket 601 is mentioned, but depending on the relative positions of the first detection terminal 613a and the second detection terminal 613b, an embodiment in which the detection terminals 613a and 613b are electrically in contact with each other in a state in which the tray 443 is inserted into the socket 601 may be implemented.

According to an embodiment, the first detection terminal 613a may be implemented using any one of the support pieces 415 of FIG. 5. In an embodiment not shown, all of the support pieces 415 of FIG. 5 may be implemented as the first detection terminal 613a. For example, two first detection terminals 613a (and/or two second detection terminals 613b) may be provided in one socket 601. In the embodiment of FIG. 5, the tray 443 may include support recesses 443d respectively corresponding to the support pieces 415. When at least one of the support pieces 415 of FIG. 5 is implemented as the first detection terminal 613a, the second support recess 443e corresponding to the first detection terminal 613a may be formed to have a depth smaller than that of the support recess 443d of FIG. 5. In an embodiment, when one of the support pieces 415 of FIG. 5 is implemented as the first detection terminal 613a, the tray 443 may not include the second support recess 443e at a position corresponding to the first detection terminal 613a. Here, the 'position corresponding to the first detection terminal 613a' may refer to a portion (e.g., a portion of a side surface of the seating part 443a) in contact with the interference portion 623b in a state in which the tray 443 is sufficiently or completely inserted into the socket 601.

According to an embodiment, the first detection terminal 613a may fix or support the tray 443 inside the socket 601, similar to the support piece 415 of FIG. 5, and even if the second support recess 443e is provided, the interference portion 623b may move outward of the socket 601 along the second direction D2 (e.g., the X-axis direction of FIGS. 1 to 3) by contacting the tray 443. For example, in a structure in which the first detection terminal 613a is disposed on the sidewalls SS1 and SS2 of the receiving space 411, whether the second support recess 443e is formed or the depth of the second support recess 443e may be determined considering movement according to contact with the tray 443 and electrical contact/separation with the second detection terminal 613b.

According to an embodiment, additional embodiments may be implemented by selectively combining the configurations of the above-described embodiments. For example, such a structure may be implemented in which the first detection terminal 413a, 513a, or 613a and/or the second detection terminal 413b, 513b, or 613b is disposed on the tray guide structure to move or deform in a direction (e.g., the Z-axis direction or the X-axis direction of FIGS. 1 to 3 as the second direction D2) crossing the tray insertion direction (e.g., the Y-axis direction of FIGS. 1 to 3 as the first direction D1). In an embodiment, as the detection structure is substantially implemented by a portion (e.g., an upper shell and/or a lower shell) of the socket 341, 401, 501, or 601, and/or is disposed on the tray guide structure, the socket 341, 401, 501, or 601 may be downsized.

According to an embodiment, in a structure in which the first detection terminal 413a, 513a, or 613a and/or the second detection terminal 413b, 513b, or 613b are simultaneously deformed by contact with the tray 443, the load generated by the deformation may be distributed to the first detection terminal 413a, 513a, or 613a and the second detection terminal 413b, 513b, or 613b. In an embodiment, in a structure in which one of the first detection terminal 413a, 513a, or 613a and the second detection terminal 413b, 513b, or 613b is fixed and the other is deformed by contact with the tray 443, the tray 443 may include an avoidance recess 449a and/or an interference piece 449b, thereby reducing the load generated due to deformation. The load generated due to deformation substantially presses the tray 443 in the second direction D2 crossing the first direction D1, so that the tray 443 may be stably disposed inside the socket 341, 401, 501, or 601. For example, durability of the socket 341, 401, 501, or 601 and/or stability in the tray 443 mounting structure may be enhanced.

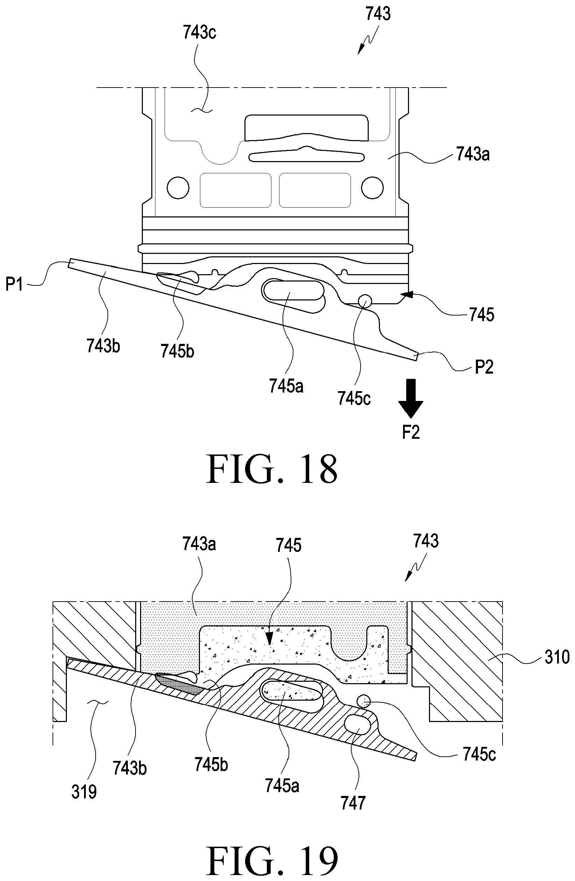

FIG. 16 is a view illustrating a tray of an electronic device according to an embodiment of the disclosure. FIG. 17 is a view illustrating a state in which the tray of FIG. 16 is inserted into an inside of a housing or a side structure according to an embodiment of the disclosure. FIG. 18 is a view illustrating a state in which a head part is rotated in the tray of FIG. 16, according to an embodiment of the disclosure. FIG. 19 is a view illustrating a state in which the tray of FIG. 18 is inserted into an inside of a housing or a side structure according to an embodiment of the disclosure.

The configuration of the tray 743 of FIGS. 16 to 19 including the seating part 743a defining the seating area 743c and the head part 743b may be similar to those of the previous embodiments, and thus a detailed description thereof will be omitted. Referring to FIGS. 16 to 19, the head part 743b of the tray 743 (e.g., the trays 343 and 443 of FIGS. 3 to 5) may be rotatably coupled to the seating part 743a. For example, the tray 743 may include a supporting part 745 provided between the seating part 743a and the head part 743b, and the head part 743b may be rotatably coupled to the supporting part 745. The axis of rotation may be perpendicular to the sliding direction of the tray, e.g. perpendicular to the first direction D1. In an embodiment, the supporting part 745 may be understood as a portion of the seating part 743a. According to an embodiment, the supporting part 745 may be formed of an elastic body such as a silicone resin or a urethane resin. For example, the supporting part 745 may be manufactured to be coupled to the seating part 743a while being simultaneously formed by insert injection molding. In an embodiment, when no external force is applied, the supporting part 745 may maintain the head part 743b at the initial assembly position. The 'initial assembly position' of the head part 743b may refer to a position where a portion of the head part 743b forms a flat or curved surface continuous to an outer surface of the side structure 310 in a state in which the tray 743 is mounted on a housing (e.g., the side structure 310 of FIG. 4) or a socket (e.g., the socket 341, 401, 501, or 601 in the above-described embodiments).

According to an embodiment, the supporting part 745 may include an engaging protrusion 745a, a stopper protrusion 745c, and/or an elastic piece 745b. The engaging protrusion 745a may be disposed or engaged to pass through, e.g., a portion of the head part 743b to couple the head part 743b to the supporting part 745 and/or the seating part 743a in a rotatable state. By including an elastic material as the engaging protrusion 745a itself, the head part 743b may be maintained at the initial assembly position (e.g., the position illustrated in FIG. 16) for the supporting part 745 and/or the seating part 743a. The stopper protrusion 745c may be disposed on one side of the engaging protrusion 745a and may be at least partially engaged with the head part 743b. For example, the head part 743b may include a stopper recess 747 corresponding to the stopper protrusion 745c, and the stopper protrusion 745c may be engaged with the stopper recess 747 at the initial assembly position.

According to an embodiment, the elastic piece 745b may press the head part 743b on the other side of the engaging protrusion 745a. For example, with respect to the state illustrated in FIG. 16 or 17, the elastic force of the elastic piece 745b may act as a force for rotating the head part 743b counterclockwise about the engaging protrusion 745a. In the state illustrated in FIG. 16 or 17, a portion of the head part 743b (e.g., a portion in which the stopper protrusion 745c and/or the stopper recess 747 is disposed) is substantially in contact with the supporting part 745 (or the seating part 743a), and thus may be maintained in a stationary state even when an elastic force of the elastic piece 745b is applied. As such, the head part 743b may be supported by its own shape and/or the supporting part 745 (e.g., the engaging protrusion 745a, the stopper protrusion 745c, and/or the elastic piece 745b), and thus may be aligned at the initial assembly position, e.g., to form a flat or curved surface continuous to the outer surface of the housing or the side structure 310.

According to an embodiment, in the state illustrated in FIG. 16 or 17, the other portion of the head part 743b is supported by the elastic piece 745b but does not contact the supporting part 745 (or the seating part 743a), so that when a first external force F1 is applied to the P1 portion of the head part 743b, the head part 743b may be rotated clockwise about the engaging protrusion 745a. In an embodiment, the opening 319 of the housing (e.g., the side structure 310) may provide a space for allowing rotation of the head part 743b. When the head part 743b rotates clockwise by a designated angle, the elastic piece 745b may be deformed to accumulate an elastic force, and the stopper protrusion 745c may be separated from the stopper recess 747 to support the outer surface of the head part 743b. In an embodiment, the supporting force of the stopper protrusion 745c may be greater than the elastic force of the elastic piece 745b. For example, when the stopper protrusion 745c supports the outer surface of the head part 743b, even when the elastic force of the elastic piece 745b is applied, the head part 743b may rotate clockwise to maintain a stationary state (e.g., the state illustrated in FIG. 18 or FIG. 19). In the state illustrated in FIG. 18 or 19, the P2 portion of the head part 743b may substantially protrude to the outside of the side structure 301. For example, the user may separate the tray 743 from the side structure 310 or the socket 341, 401, 501, or 601 by pressing the P1 portion to allow the P2 portion to protrude outward of the side structure 310 and applying a second external force F2 to pull the P2 portion.

According to an embodiment, when the tray 743 is separated from the side structure 310 or the socket 341, 401, 501, or 601, a mechanical structure, such as a push-pull structure or a pivoting lever structure, may be utilized. Such a mechanical structure may be for facilitating separation of the tray 743 in a structure in which the head part 743b is disposed to substantially form a surface continuous to the outer surface of the side structure 310. According to an embodiment(s) of the disclosure, the head part 743b of the tray 743 may selectively protrude from the outer surface of the side structure 310. For example, even without disposing a mechanical structure, the user may easily separate the tray 743 from the side structure 310 or the socket 341, 401, 501, or 601. When the mechanical structure for separating the tray 743 is not disposed, at least the socket 341, 401, 501, or 601 may be further downsized, and/or the electronic device 300 may be downsized or the degree of design freedom may be enhanced in the arrangement of other components inside the electronic device 300.

According to an embodiment(s) of the disclosure, as the tray detection structure is disposed on the tray guide structure inside the socket 341, 401, 501, or 601 and/or substantially in the receiving space 411 of the tray, it is possible to easily downsize the socket 341, 401, 501, or 601 for mounting the tray 443. As the tray detection structure is configured to press the tray 443 in a direction (e.g., the Z-axis direction or the X-axis direction of FIGS. 1 to 3) crossing the tray 443 insertion direction (e.g., the Y-axis direction of FIGS. 1 to 3), it is possible to stably maintain the state in which the tray 443 is received in the socket (e.g., the Y-axis direction of FIGS. 1 to 3).

Effects of the disclosure are not limited to the foregoing, and other unmentioned effects would be apparent to one of ordinary skill in the art from the description of the foregoing embodiment(s).

According to an embodiment of the disclosure, a socket (e.g., the socket 341, 401, 501, 601 of FIG. 3, FIG. 4, FIG. 5, FIG. 10, and/or FIG. 14) for mounting a storage medium tray (e.g., the tray 343, 443, 743 of FIG. 3, FIG. 4, FIG. 5, and/or FIG. 16) may comprise a receiving space (e.g., the receiving space 411 of FIG. 6) receiving a tray. The socket for mounting the storage medium tray may comprise a lower shell (e.g., the lower shell 401a of FIG. 5 and/or FIG. 6) providing a bottom surface of the receiving space. The socket for mounting the storage medium tray may comprise an upper shell (e.g., the upper shell 401b of FIG. 5 and/or FIG. 6) coupled to the lower shell to face the lower shell to provide at least some of sidewalls of the receiving space and an upper surface of the receiving space. The socket for mounting the storage medium tray may comprise a first detection terminal (e.g., the first detection terminal 413a, 513a, 613a of FIG. 5, FIG. 10, FIG. 14) disposed between the bottom surface and the upper surface and at least partially extending along a first direction in which the tray is inserted into the receiving space. The socket for mounting the storage medium tray may comprise a second detection terminal (e.g., the second detection terminal 413b, 513b, 613b of FIG. 5, FIG. 10, FIG. 14) provided in a space between the lower shell and the upper shell and configured to electrically contact the first detection terminal. In an embodiment, as the tray moves along the first direction in the receiving space, the first detection terminal may be configured to move or deform in a second direction crossing the first direction while slidingly contacting the tray.

According to an embodiment, the first detection terminal may be configured to be electrically separated from the second detection terminal as the first detection terminal moves or deforms in the second direction while contacting the tray.

According to an embodiment, the upper shell may at least partially include an electrically conductive material. In an embodiment, the first detection terminal may extend from the upper shell to protrude from the upper surface to the receiving space.

According to an embodiment, the first detection terminal may include a first inclined portion (e.g., the first inclined portion 423a of FIG. 7) extending from the upper shell to be inclined with respect to the upper surface. The first detection terminal may include a second inclined portion (e.g., the second inclined portion 423b of FIG. 7) extending from an end portion of the first inclined portion to be inclined with respect to the upper surface and the first inclined portion. In an embodiment, at least a portion of the first inclined portion or the second inclined portion may be configured to slidingly contact the tray inserted into the receiving space.

According to an embodiment, the second detection terminal may include a third inclined portion (e.g., the third inclined portion 423c of FIG. 7) extending from the lower shell to be inclined with respect to the lower surface. The second detection terminal may include a fourth inclined portion (e.g., the fourth inclined portion 423d of FIG. 7) extending from an end portion of the third inclined portion to be inclined with respect to the lower surface and the third inclined portion. In an embodiment, at least a portion of the third inclined portion or the fourth inclined portion may be configured to electrically contact the first detection terminal.

According to an embodiment, the first detection terminal may include a fixing portion (e.g., the fixing portion 523a of FIG. 11) disposed on the lower shell. The first detection terminal may include an extension (e.g., the extension 523b of FIG. 11) extending from the fixing portion and at least partially disposed in parallel to the first direction or the upper surface in the receiving space. In an embodiment, the extension may be configured to slidingly contact the tray inserted into the receiving space.

According to an embodiment, the upper shell may at least partially include an electrically conductive material. In an embodiment, the first detection terminal may extend (e.g., see FIG. 14) from the upper shell to be inclined with respect to the sidewall and be configured to slidingly contact a side surface of the tray inserted into the receiving space.

According to an embodiment, the second detection terminal may be disposed on the lower shell and configured to electrically contact an end portion of the first detection terminal.

According to an embodiment of the disclosure, an electronic device (e.g., the electronic device 100, 300 of FIGS. 1 to 3) may comprise a housing (e.g., the housing 110 of FIG. 1, the side surface 310 of FIG. 3 and/or FIG. 4) including an opening (e.g., the opening 319 of FIG. 14) provided through a side surface. The electronic device may comprise a tray (e.g., the tray 343, 443, 743 of FIG. 3, FIG. 4, FIG. 5, and/or FIG. 16) configured to be at least partially inserted into an inside of the housing through the opening while receiving at least one storage medium. The electronic device may comprise a socket (e.g., the socket 341, 401, 501, 601 of FIG. 3, FIG. 4, FIG. 5, FIG. 10, and/or FIG. 14) disposed in the housing, aligned with the opening, and configured to receive at least a portion of the tray. In an embodiment, the socket may include a receiving space (e.g., the receiving space 411 of FIG. 6) receiving a tray. The socket may include a lower shell (e.g., the lower shell 401a of FIG. 5 and/or FIG. 6) providing a bottom surface of the receiving space. The socket may include an upper shell (e.g., the upper shell 401b of FIG. 5 and/or FIG. 6) coupled to the lower shell to face the lower shell to provide at least some of sidewalls of the receiving space and an upper surface of the receiving space. The socket may include a first detection terminal (e.g., the first detection terminal 413a, 513a, 613a of FIG. 5, FIG. 10, FIG. 14) disposed between the bottom surface and the upper surface and at least partially extending along a first direction in which the tray is inserted into the receiving space. The socket may include a second detection terminal (e.g., the second detection terminal 413b, 513b, 613b of FIG. 5, FIG. 10, FIG. 14) provided in a space between the lower shell and the upper shell and configured to electrically contact the first detection terminal. In an embodiment, as the tray moves along the first direction in the receiving space, the first detection terminal may be configured to move or deform in a second direction crossing the first direction while slidingly contacting the tray.

According to an embodiment, the first detection terminal may be configured to be electrically separated from the second detection terminal as the first detection terminal moves or deforms in the second direction while contacting the tray.

According to an embodiment, the upper shell may at least partially include an electrically conductive material. In an embodiment, the first detection terminal may extend from the upper shell to protrude from the upper surface to the receiving space.

According to an embodiment, the first detection terminal may include a first inclined portion (e.g., the first inclined portion 423a of FIG. 7) extending from the upper shell to be inclined with respect to the upper surface. The first detection terminal may include a second inclined portion (e.g., the second inclined portion 423b of FIG. 7) extending from an end portion of the first inclined portion to be inclined with respect to the upper surface and the first inclined portion. In an embodiment, at least a portion of the first inclined portion or the second inclined portion may be configured to slidingly contact the tray inserted into the receiving space.

According to an embodiment, the second detection terminal may include a third inclined portion (e.g., the third inclined portion 423c of FIG. 7) extending from the lower shell to be inclined with respect to the lower surface. The second detection terminal may include a fourth inclined portion (e.g., the fourth inclined portion 423d of FIG. 7) extending from an end portion of the third inclined portion to be inclined with respect to the lower surface and the third inclined portion. In an embodiment, at least a portion of the third inclined portion or the fourth inclined portion may be configured to electrically contact the first detection terminal.

According to an embodiment, the first detection terminal may include a fixing portion (e.g., the fixing portion 523a of FIG. 11) disposed on the lower shell. The first detection terminal may include an extension (e.g., the extension 523b of FIG. 11) extending from the fixing portion and at least partially disposed in parallel to the first direction or the upper surface in the receiving space. In an embodiment, the extension may be configured to slidingly contact the tray inserted into the receiving space.

According to an embodiment, the upper shell may at least partially include an electrically conductive material. In an embodiment, the first detection terminal may extend (e.g., see FIG. 14) from the upper shell to be inclined with respect to the sidewall and be configured to slidingly contact a side surface of the tray inserted into the receiving space.

According to an embodiment, the second detection terminal may be disposed on the lower shell and configured to electrically contact an end portion of the first detection terminal.

According to an embodiment, the tray may include a seating part (e.g., the seating part 343a, 443a, 743a of FIG. 4, FIG. 5, and/or FIG. 16) configured to be inserted into or withdrawn from the housing along the first direction while receiving at least one storage medium. The tray may include a supporting part (e.g., the supporting part 745 of FIG. 16) disposed on the seating part. The tray may include a head part (e.g., the head part 343b, 443b, 743b of FIG. 4, FIG. 5, and/or FIG. 16) rotatably coupled to the supporting part.

According to an embodiment, the head part may be configured to be aligned to at least partially form a flat or curved surface continuous to an outer surface of the housing in a state in which the tray is inserted in the housing.

According to an embodiment, the supporting part may be configured to support the head part in the state of being aligned to form the flat or curved surface continuous to the outer surface of the housing by providing an elastic force to the head part.

According to an embodiment, the head part may be configured to at least partially protrude from an outer surface of the housing by rotating about the seating part or the supporting part in a state in which the tray is inserted in the housing.

While the disclosure has been described and shown in connection with an embodiment thereof, it should be appreciated that an embodiment is intended as limiting the invention but as illustrative. It will be apparent to one of ordinary skill in the art that various changes may be made in form and detail without departing from the overall scope of the invention, which is defined by the appended claims.

## Claims

1. A socket (341; 401; 501; 601) for mounting a storage medium tray (343; 443; 743), comprising:
a receiving space (411) for receiving a tray (343; 443; 743);
a lower shell (401a) providing a bottom surface of the receiving space;
an upper shell (401b) coupled to the lower shell (401a) to face the lower shell (401a) to provide at least a portion of sidewalls of the receiving space and an upper surface of the receiving space;
a first detection terminal (413a; 513a; 613a) disposed between the bottom surface and the upper surface and at least partially extending along a first direction in which the tray (343; 443; 743) is inserted into the receiving space; and
a second detection terminal (413b; 513b; 613b) provided between the lower shell (401a) and the upper shell (401b) and configured to electrically contact the first detection (413a; 513a; 613a) terminal,
wherein the first detection terminal (413a; 513a; 613a) is configured to move or deform in a second direction crossing the first direction and being substantially perpendicular to the first direction while slidingly contacting the tray (343; 443; 743) as the tray (343; 443; 743) moves along the first direction in the receiving space,
wherein the upper shell (401b) at least partially includes an electrically conductive material, wherein the first detection terminal (413a; 513a; 613a) is a portion of the upper shell (401b) including the electrically conductive material,
**characterised in that**
the first detection terminal (413a; 513a; 613a) extends from the upper shell (401b) to be inclined with respect to the sidewalls and is configured to slidingly contact a side surface of the tray (343; 443; 743) inserted into the receiving space.

2. The socket (341; 401; 501; 601) of claim 1, wherein the first detection terminal (413a; 513a; 613a) is configured to be electrically separated from the second detection terminal (413b; 513b; 613b) as the first detection terminal (413a; 513a; 613a) moves or deforms in the second direction while contacting the tray (343; 443; 743).

3. The socket (341; 401; 501; 601) of any one of claims 1 to 2,
wherein the first detection terminal extends from the upper shell (401b) to protrude from the upper surface to the receiving space.

4. The socket (341; 401; 501) of claim 3, wherein the first detection terminal includes:
a first inclined portion (423a) extending from the upper shell (401b) to be inclined with respect to the upper surface; and
a second inclined portion (423b) extending from an end portion of the first inclined portion to be inclined with respect to the upper surface and the first inclined portion, and
wherein at least a portion of the first inclined portion or the second inclined portion is configured to slidingly contact the tray (343; 443; 743) inserted into the receiving space.

5. The socket (341; 401; 501) of claim 4, wherein the second detection terminal includes:
a third inclined portion (423c) extending from the lower shell (401a) to be inclined with respect to the lower surface; and
a fourth inclined portion (423d) extending from an end portion of the third inclined portion to be inclined with respect to the lower surface and the third inclined portion, and
wherein at least a portion of the third inclined portion or the fourth inclined portion is configured to electrically contact the first detection terminal.

6. The socket (341; 401; 501; 601) of any one of claims 1 to 2, wherein the first detection terminal includes:
a fixing portion (523a) disposed on the lower shell (401a); and
an extension (523b) extending from the fixing portion and at least partially disposed in parallel to the first direction or the upper surface in the receiving space, and
wherein the extension is configured to slidingly contact the tray (343; 443; 743) inserted into the receiving space.

7. The socket of claim 1, wherein the second detection terminal is disposed on the lower shell (401a) and configured to electrically contact an end portion of the first detection terminal.

8. An electronic device (100; 300), comprising:
a housing (110, 310) including an opening (319) provided through a side surface;
a tray (343; 443; 743) configured to be at least partially insertable into an inside of the housing through the opening and capable of accommodating at least one storage medium; and
a socket (341; 401; 501; 601) according to one of claims 1 to 7, which is disposed in the housing, aligned with the opening, and configured to receive at least a portion of the tray (343; 443; 743).

9. The electronic device of claim 8, wherein the first detection terminal is configured to be electrically separated from the second detection terminal as the first detection terminal moves or deforms in the second direction while contacting the tray.

10. The electronic device of any one of claims 8 to 9, wherein the upper shell at least partially includes an electrically conductive material, and
wherein the first detection terminal extends from the upper shell to protrude from the upper surface to the receiving space.

11. The electronic device of claim 8 to 10, wherein the tray (343; 443; 743) includes:
a seating part (343a; 443a; 743a) configured to be inserted into or withdrawn from the housing along the first direction and capable of accommodating at least one storage medium;
a supporting part (745) disposed on the seating part; and
a head part (343b; 443b; 743b) rotatably coupled to the supporting part.

12. The electronic device of claim 11, wherein the head part is configured to be aligned to at least partially form a flat or curved surface continuous to an outer surface of the housing in a state in which the tray (343; 443; 743) is inserted in the housing.

13. The electronic device of claim 12, wherein the supporting part is configured to support the head part in the state of being aligned to form the flat or curved surface continuous to the outer surface of the housing by providing an elastic force to the head part.

14. The electronic device of any one of claims 11 to 13, wherein the head part is configured to at least partially protrude from an outer surface of the housing by rotating about the seating part or the supporting part in a state in which the tray (343; 443; 743) is inserted in the housing.

## Patentansprüche

1. Sockel (341; 401; 501; 601) zur Montage eines Speichermedientabletts (343; 443; 743), umfassend:
einen Aufnahmeraum (411) zur Aufnahme eines Tabletts (343; 443; 743);
eine untere Hülle (401a), die eine Bodenfläche des Aufnahmeraums bereitstellt;
eine obere Hülle (401b), die mit der unteren Hülle (401a) so gekoppelt ist, dass sie der unteren Hülle (401a) zugewandt ist, um mindestens einen Abschnitt der Seitenwände des Aufnahmeraums und eine Oberseite des Aufnahmeraums bereitzustellen;
einen ersten Erfassungsanschluss (413a; 513a; 613a), der zwischen der Bodenfläche und der Oberseite angeordnet ist und sich zumindest teilweise entlang einer ersten Richtung erstreckt, in der das Tablett (343; 443; 743) in den Aufnahmebereich eingeführt wird; und
einen zweiten Erfassungsanschluss (413b; 513b; 613b), der zwischen der unteren Hülle (401a) und der oberen Hülle (401b) vorgesehen und so konfiguriert ist, dass er elektrisch mit dem ersten Erfassungsanschluss (413a; 513a; 613a) in Kontakt steht,
wobei der erste Erfassungsanschluss (413a; 513a; 613a) so konfiguriert ist, dass er sich in einer zweiten Richtung bewegt oder verformt, die die erste Richtung kreuzt und im Wesentlichen senkrecht zur ersten Richtung verläuft, während er das Tablett (343; 443; 743) gleitend berührt, wenn sich das Tablett (343; 443; 743) entlang der ersten Richtung im Aufnahmeraum bewegt,
wobei die obere Hülle (401b) zumindest teilweise ein elektrisch leitfähiges Material umfasst, wobei der erste Erfassungsanschluss (413a; 513a; 613a) ein Abschnitt der oberen Hülle (401b) ist, der das elektrisch leitfähige Material umfasst,
**dadurch gekennzeichnet, dass**
der erste Erfassungsanschluss (413a; 513a; 613a) sich von der oberen Hülle (401b) aus erstreckt, um in Bezug auf die Seitenwände geneigt zu sein, und so konfiguriert ist, dass er eine Seitenfläche des in den Aufnahmeraum eingeführten Tabletts (343; 443; 743) gleitend berührt.

2. Sockel (341; 401; 501; 601) nach Anspruch 1, wobei der erste Erfassungsanschluss (413a; 513a; 613a) so konfiguriert ist, dass er elektrisch vom zweiten Erfassungsanschluss (413b; 513b; 613b) getrennt wird, wenn sich der erste Erfassungsanschluss (413a; 513a; 613a) in der zweiten Richtung bewegt oder verformt, während er das Tablett (343; 443; 743) berührt.

3. Sockel (341; 401; 501; 601) nach einem der Ansprüche 1 bis 2,
wobei sich der erste Erfassungsanschluss von der oberen Hülle (401b) erstreckt, um von der Oberseite in den Aufnahmeraum vorzustehen.

4. Sockel (341; 401; 501) nach Anspruch 3, wobei der erste Erfassungsanschluss Folgendes umfasst:
einen ersten geneigten Abschnitt (423a), der sich von der oberen Hülle (401b) erstreckt, um in Bezug auf die Oberseite geneigt zu sein; und
einen zweiten geneigten Abschnitt (423b), der sich von einem Endabschnitt des ersten geneigten Abschnitts erstreckt, um in Bezug auf die Oberseite und den ersten geneigten Abschnitt geneigt zu sein, und
wobei mindestens ein Abschnitt von dem ersten geneigten Abschnitt und dem zweiten geneigten Abschnitt so konfiguriert ist, dass er das in den Aufnahmeraum eingeführte Tablett (343; 443; 743) gleitend berührt.

5. Sockel (341; 401; 501) nach Anspruch 4, wobei der zweite Erfassungsanschluss Folgendes umfasst:
einen dritten geneigten Abschnitt (423c), der sich von der unteren Hülle (401a) erstreckt, um in Bezug auf die Unterseite geneigt zu sein; und
einen vierten geneigten Abschnitt (423d), der sich von einem Endabschnitt des dritten geneigten Abschnitts erstreckt, um in Bezug auf die Unterseite und den dritten geneigten Abschnitt geneigt zu sein, und
wobei mindestens ein Abschnitt von dem dritten geneigten Abschnitt und dem vierten geneigten Abschnitt so konfiguriert ist, dass er elektrisch mit dem ersten Erfassungsanschluss in Kontakt steht.

6. Sockel (341; 401; 501; 601) nach einem der Ansprüche 1 bis 2, wobei der erste Erfassungsanschluss Folgendes umfasst:
einen Befestigungsabschnitt (523a), der an der unteren Hülle (401a) angeordnet ist; und
eine Verlängerung (523b), die sich von dem Befestigungsabschnitt erstreckt und zumindest teilweise parallel zu der ersten Richtung oder der Oberseite in dem Aufnahmeraum angeordnet ist, und
wobei die Verlängerung so konfiguriert ist, dass sie das in den Aufnahmeraum eingeführte Tablett (343; 443; 743) gleitend berührt.

7. Sockel nach Anspruch 1, wobei der zweite Erfassungsanschluss an der unteren Hülle (401a) angeordnet und so konfiguriert ist, dass er elektrisch mit einem Endabschnitt des ersten Erfassungsanschlusses in Kontakt steht.

8. Elektronisches Gerät (100; 300), umfassend:
ein Gehäuse (110, 310) mit einer Öffnung (319), die durch eine Seitenfläche hindurch vorgesehen ist;
ein Tablett (343; 443; 743), das so konfiguriert ist, dass es zumindest teilweise durch die Öffnung in das Innere des Gehäuses eingeführt werden und mindestens ein Speichermedium aufnehmen kann; und
einen Sockel (341; 401; 501; 601) nach einem der Ansprüche 1 bis 7, der in dem Gehäuse angeordnet, mit der Öffnung ausgerichtet und dazu konfiguriert ist, mindestens einen Abschnitt des Tabletts (343; 443; 743) aufzunehmen.

9. Elektronisches Gerät nach Anspruch 8, wobei der erste Erfassungsanschluss so konfiguriert ist, dass er elektrisch vom zweiten Erfassungsanschluss getrennt wird, wenn sich der erste Erfassungsanschluss in der zweiten Richtung bewegt oder verformt, während er das Tablett berührt.

10. Elektronisches Gerät nach einem der Ansprüche 8 bis 9, wobei die obere Hülle zumindest teilweise ein elektrisch leitfähiges Material umfasst, und
wobei sich der erste Erfassungsanschluss von der oberen Hülle erstreckt, um von der Oberseite in den Aufnahmeraum vorzustehen.

11. Elektronisches Gerät nach Anspruch 8 bis 10, wobei das Tablett (343; 443; 743) Folgendes umfasst:
ein Sitzteil (343a; 443a; 743a), das so konfiguriert ist, dass es entlang der ersten Richtung in das Gehäuse eingeführt oder aus diesem herausgezogen werden und mindestens ein Speichermedium aufnehmen kann;
ein Stützteil (745), das auf dem Sitzteil angeordnet ist; und
ein Kopfteil (343b; 443b; 743b), das drehbar mit dem Stützteil gekoppelt ist.

12. Elektronisches Gerät nach Anspruch 11, wobei das Kopfteil so konfiguriert ist, dass es ausgerichtet werden kann, um zumindest teilweise eine flache oder gekrümmte Oberfläche zu bilden, die in einem Zustand, in dem das Tablett (343; 443; 743) in das Gehäuse eingeführt ist, an eine Außenfläche des Gehäuses anschließt.

13. Elektronisches Gerät nach Anspruch 12, wobei das Stützteil dazu konfiguriert ist, das Kopfteil in dem Zustand zu stützen, in dem dieses ausgerichtet ist, um die flache oder gekrümmte Oberfläche zu bilden, die sich an die Außenfläche des Gehäuses anschließt, indem es eine elastische Kraft auf das Kopfteil ausübt.

14. Elektronisches Gerät nach einem der Ansprüche 11 bis 13, wobei das Kopfteil so konfiguriert ist, dass es zumindest teilweise von einer Außenfläche des Gehäuses vorsteht, indem es sich in dem Zustand, in dem das Tablett (343; 443; 743) in das Gehäuse eingeführt ist, um das Sitzteil oder das Stützteil dreht.

## Revendications

1. Douille (341; 401; 501; 601) destinée à monter un plateau de support de stockage (343; 443; 743), comprenant :
un espace de réception (411) pour recevoir un plateau (343; 443; 743) ;
une coquille inférieure (401a) fournissant une surface inférieure de l'espace de réception;
une coquille supérieure (401b) couplée à la coquille inférieure (401a) pour faire face à la coquille inférieure (401a) afin de fournir au moins une partie de parois latérales de l'espace de réception et une surface supérieure de l'espace de réception ;
une première borne de détection (413a; 513a; 613a) disposée entre la surface inférieure et la surface supérieure et au moins partiellement s'étendant le long d'une première direction dans laquelle le plateau (343; 443; 743) est inséré dans l'espace de réception ; et
une seconde borne de détection (413b; 513b; 613b) prévue entre la coquille inférieure (401a) et la coquille supérieure (401b) et configurée pour entrer en contact électrique avec la première borne de détection (413a; 513a; 613a),
dans lequel la première borne de détection (413a; 513a; 613a) est configurée pour se déplacer ou se déformer dans une seconde direction croisant la première direction et étant sensiblement perpendiculaire à la première direction tout en entrant en contact glissant avec le plateau (343; 443; 743) lorsque le plateau (343; 443; 743) se déplace le long de la première direction dans l'espace de réception,
dans lequel la coquille supérieure (401b) au moins partiellement comporte un matériau électriquement conducteur, dans lequel la première borne de détection (413a; 513a; 613a) est une partie de la coquille supérieure (401b) comportant le matériau électriquement conducteur,
**caractérisé en ce que**
la première borne de détection (413a; 513a; 613a) s'étend à partir de la coquille supérieure (401b) pour être inclinée par rapport aux parois latérales et est configurée pour entrer en contact glissant avec une surface latérale du plateau (343; 443; 743) inséré dans l'espace de réception.

2. Douille (341; 401; 501; 601) selon la revendication 1, dans lequel la première borne de détection (413a; 513a; 613a) est configurée pour être séparée électriquement à partir de la seconde borne de détection (413b; 513b; 613b) lorsque la première borne de détection (413a; 513a; 613a) se déplace ou se déforme dans la seconde direction tout en entrant en contact avec le plateau (343; 443; 743).

3. Douille (341; 401; 501; 601) selon l'une quelconque des revendications 1 à 2,
dans lequel la première borne de détection s'étend à partir de la coquille supérieure (401b) pour faire saillie à partir de la surface supérieure vers l'espace de réception.

4. Douille (341; 401; 501) selon la revendication 3, dans lequel la première borne de détection comporte :
une première partie inclinée (423a) s'étendant à partir de la coquille supérieure (401b) pour être inclinée par rapport à la surface supérieure ; et
une deuxième partie inclinée (423b) s'étendant à partir d'une partie d'extrémité de la première partie inclinée pour être inclinée par rapport à la surface supérieure et à la première partie inclinée, et
dans lequel au moins une partie de la première partie inclinée ou de la deuxième partie inclinée est configurée pour entrer en contact glissant avec le plateau (343; 443; 743) inséré dans l'espace de réception.

5. Douille (341; 401; 501) selon la revendication 4, dans lequel la seconde borne de détection comporte :
une troisième partie inclinée (423c) s'étendant à partir de la coquille inférieure (401a) pour être inclinée par rapport à la surface inférieure ; et
une quatrième partie inclinée (423d) s'étendant à partir d'une partie d'extrémité de la troisième partie inclinée pour être inclinée par rapport à la surface inférieure et à la troisième partie inclinée, et
dans lequel au moins une partie de la troisième partie inclinée ou de la quatrième partie inclinée est configurée pour entrer en contact électrique avec la première borne de détection.

6. Douille (341; 401; 501; 601) selon l'une quelconque des revendications 1 à 2, dans lequel la première borne de détection comporte :
une partie de fixation (523a) disposée sur la coquille inférieure (401a) ; et
une extension (523b) s'étendant à partir de la partie de fixation et au moins partiellement disposée en parallèle avec la première direction ou avec la surface supérieure dans l'espace de réception, et
dans lequel l'extension est configurée pour entrer en contact glissant avec le plateau (343; 443; 743) inséré dans l'espace de réception.

7. Douille selon la revendication 1, dans lequel la seconde borne de détection est disposée sur la coquille inférieure (401a) et configurée pour entrer en contact électrique avec une partie d'extrémité de la première borne de détection.

8. Dispositif électronique (100; 300), comprenant :
un boîtier (110, 310) comportant une ouverture (319) prévue à travers une surface latérale;
un plateau (343; 443; 743) configuré pour être au moins partiellement insérable dans un intérieur du boîtier à travers l'ouverture et capable de loger au moins un support de stockage ; et
une douille (341; 401; 501; 601) selon l'une quelconque des revendications 1 à 7, qui est disposée dans le boîtier, alignée avec l'ouverture, et configurée pour recevoir au moins une partie du plateau (343; 443; 743).

9. Dispositif électronique selon la revendication 8, dans lequel la première borne de détection est configurée pour être séparée électriquement à partir de la seconde borne de détection lorsque la première borne de détection se déplace ou se déforme dans la seconde direction tout en entrant en contact avec le plateau.

10. Dispositif électronique selon l'une quelconque des revendications 8 à 9, dans lequel la coquille supérieure au moins partiellement comporte un matériau électriquement conducteur, et
dans lequel la première borne de détection s'étend à partir de la coquille supérieure pour faire saillie à partir de la surface supérieure vers l'espace de réception.

11. Dispositif électronique selon la revendication 8 à 10, dans lequel le plateau (343; 443; 743) comporte :
une partie d'assise (343a; 443a; 743a) configurée pour être insérée dans ou retirée à partir du boîtier le long de la première direction et capable de loger au moins un support de stockage;
une partie de soutien (745) disposée sur la partie d'assise ; et
une partie de tête (343b; 443b; 743b) couplée de manière rotative à la partie de soutien.

12. Dispositif électronique selon la revendication 11, dans lequel la partie de tête est configurée pour être alignée pour au moins partiellement former une surface plane ou courbe continue avec une surface extérieure du boîtier à un état dans lequel le plateau (343; 443; 743) est inséré dans le boîtier.

13. Dispositif électronique selon la revendication 12, dans lequel la partie de soutien est configurée pour soutenir la partie de tête à l'état d'être alignée pour former la surface plane ou courbe continue avec la surface extérieure du boîtier en fournissant une force élastique à la partie de tête.

14. Dispositif électronique selon l'une quelconque des revendications 11 à 13, dans lequel la partie de tête est configurée pour au moins partiellement faire saillie à partir d'une surface extérieure du boîtier en tournant autour de la partie d'assise ou de la partie de soutien à un état dans lequel le plateau (343; 443; 743) est inséré dans le boîtier.
